# EUROPEAN PATENT APPLICATION

(11) **EP 4 832 703 A1**
(43) Date of publication of application: **28.10.2026**
(21) Application number: 24907310.7
(22) Date of filing: 12.12.2024
(51) Int. Cl.: H10H 20/858, B41J 2/01, H10H 20/00, H10H 20/852, H10H 20/857

(54) **LIGHT SOURCE MODULE AND LIGHT IRRADIATION DEVICE**

(30) Priority: 19.12.2023 JP 2023213874
(71) Applicant: Kyocera Corporation, Kyoto-shi, Kyoto 612-8501 (JP)
(72) Inventor: HIOKI Ryuya, Kyoto-shi, Kyoto 612-8501 (JP)
(74) Representative: Viering, Jentschura & Partner mbB Patent- und Rechtsanwälte
(86) International application number: PCT/JP2024/044064
(87) International publication number: WO 2025/134925

(57) **Abstract**

A light source module includes a light emitter including multiple light-emitting elements, a heat dissipator, a cover including a first opening, a light-transmissive member covering the first opening, a first cable electrically connected to the light emitter, and a sealant made of a resin. The sealant covers a first clearance between the heat dissipator and the cover along a peripheral edge of the first clearance. The heat dissipator includes a base including first and second surfaces and multiple protrusions each protruding from the second surface. The light emitter is between the first surface and the light-transmissive member. The cover includes third and fourth surfaces and a receding portion on the third surface. The first opening is open in the receding portion. The first cable extends through a second opening between the receding portion and the base. The first cable extends through the sealant. The sealant covers the second opening.

## Description

### CROSS-REFERENCE TO RELATED APPLICATION

This application claims priority to Japanese Patent Application No. 2023-213874 filed on December 19, 2023, the entire disclosure of which is incorporated herein by reference.

### TECHNICAL FIELD

The present disclosure relates to a light source module and a light irradiator.

### BACKGROUND OF INVENTION

A known light irradiator includes a light source including multiple light-emitting elements, a heat dissipator thermally connected to the light source, a blower blowable toward the heat dissipator, a drive that drives the light source, and a housing containing the light source, the heat dissipator, the blower, and the drive and including multiple vents (refer to, for example, Patent Literature 1).

A light source module and a light irradiator are increasingly expected to reduce, for example, foreign matter adhering to the light emitter.

### CITATION LIST

### PATENT LITERATURE

Patent Literature 1: WO 2019/181937

### SUMMARY

A light source module and a light irradiator will be described.

In one aspect, a light source module includes a light emitter, a heat dissipator, a cover, a light-transmissive member, a first cable, and a sealant. The light emitter includes a plurality of light-emitting elements. The cover includes a first opening to allow light from the light emitter to pass. The cover is attached to the heat dissipator. The light-transmissive member covers the first opening and transmits light from the light emitter. The first cable is electrically connected to the light emitter to supply power for light emission of the plurality of light-emitting elements. The sealant covers a first clearance between the heat dissipator and the cover along a peripheral edge of the first clearance. The sealant is made of a resin. The heat dissipator includes a base being a plate and a plurality of protrusions. The base includes a first surface and a second surface opposite to the first surface. The first surface is a portion of the base adjacent to the cover. Each of the plurality of protrusions protrudes from the second surface. The light emitter is between the first surface and the light-transmissive member. The cover includes a third surface, a fourth surface opposite to the third surface, and a receding portion on the third surface. The third surface is a portion of the cover adjacent to the heat dissipator. At least a part of the base is received in an internal space in the receding portion. The first opening is open in the receding portion. The light source module further includes, between the receding portion and the base, a second opening connecting to a first area extending between the cover and the first surface. The first cable extends through the second opening. The first cable extends through the sealant. The sealant covers the second opening.

In one aspect, a light irradiator includes the light source module according to the aspect described above, a housing, and a drive. The housing surrounds, together with the cover, the light emitter and the heat dissipator. The drive includes a drive circuit that drives the light emitter. The housing includes a first vent and a second vent each connecting a first space inside the housing and a second space outside the housing. The first vent is adjacent to a plurality of second clearances between the plurality of protrusions in a direction along the first surface. The second vent is located at a position opposite to the cover with respect to the heat dissipator. The first cable electrically connects the light emitter and the drive.

### BRIEF DESCRIPTION OF THE DRAWINGS

FIG. 1 is a perspective view of a light source module according to a first embodiment, illustrating an example appearance.
FIG. 2 is a plan view of the light source module according to the first embodiment, illustrating an example appearance.
FIG. 3 is a bottom view of the light source module according to the first embodiment, illustrating an example appearance.
FIG. 4 is a schematic cross-sectional view of the light source module as viewed in a positive X-direction at position IV-IV in FIGs. 2 and 3, illustrating an example imaginary cross section of the light source module.
FIG. 5 is a schematic cross-sectional view of the light source module as viewed in the positive X-direction at position V-V in FIGs. 2 and 3, illustrating an example imaginary cross section of the light source module.
FIG. 6 is a perspective view of a cover, illustrating an example appearance.
FIG. 7 is a perspective view of the cover, illustrating an example appearance.
FIG. 8 is a perspective view of a heat dissipator, illustrating an example appearance.
FIG. 9 is a perspective view of the heat dissipator, illustrating an example appearance.
FIG. 10 is a front view of the heat dissipator, illustrating an example appearance.
FIG. 11 is a side view of the heat dissipator, illustrating an example appearance.
FIG. 12 is a side view of a first unit including a light emitter, a first cable, and a second cable attached to a heat dissipator, illustrating an example appearance.
FIG. 13 is a perspective view of a first module including the light emitter, the first cable, and the second cable each attached to the heat dissipator located on a cover, illustrating an example appearance.
FIG. 14 is a plan view of the first module including the light emitter, the first cable, and the second cable each attached to the heat dissipator on the cover, illustrating an example appearance.
FIG. 15 is a schematic cross-sectional view of the first module as viewed in the positive X-direction at position XV-XV in FIG. 14, illustrating an imaginary cross section of the first module.
FIG. 16 is a schematic cross-sectional view of the first module as viewed in the positive X-direction at position XVI-XVI in FIG. 14, illustrating an imaginary cross section of the first module.
FIG. 17 is a schematic cross-sectional view of the first module in FIG. 16 in an example state with the heat dissipator and the cover being fastened together with screws.
FIG. 18 is a side view of a light irradiator according to the first embodiment, illustrating an example appearance.
FIG. 19 is a bottom view of the light irradiator according to the first embodiment, illustrating an example appearance.
FIG. 20 is a schematic cross-sectional view of the light irradiator according to the first embodiment, illustrating an example structure.
FIG. 21 is a cross-sectional view of the light irradiator according to the first embodiment, illustrating another example structure.
FIG. 22 is a schematic diagram of an example printing apparatus in the first embodiment.
FIG. 23 is a perspective view of a light source module according to a second embodiment, illustrating an example appearance.
FIG. 24 is a schematic cross-sectional view of the light source module according to the second embodiment, illustrating an example cross section.
FIG. 25 is a schematic cross-sectional view of a light source module according to a third embodiment, illustrating an example cross section.
FIG. 26 is a schematic cross-sectional view of a light source module according to a fourth embodiment, illustrating an example cross section.

### DESCRIPTION OF EMBODIMENTS

A known light irradiator includes a light source including multiple light-emitting elements, a heat dissipator thermally connected to the light source, a blower blowable toward the heat dissipator, a drive that drives the light source, and a housing containing the light source, the heat dissipator, the blower, and the drive and including multiple vents.

The light irradiator may be used in, for example, a printing apparatus that prints by applying ink containing a photosensitive material onto a print medium such as a paper sheet.

A printing apparatus may produce fine droplets of ink (also referred to as ink mist) when, for example, a printing unit such as an inkjet head ejects droplets of ink containing a photosensitive material toward a print medium such as a paper sheet. The printing apparatus also causes dust, such as powdery substances on a paper sheet (also referred to as paper dust), to rise while, for example, feeding a print medium such as a paper sheet. For example, a light irradiator used in the printing apparatus may have electrical or optical failures caused by foreign matter such as ink mist, dust, and dirt adhering to the light emitter. Electrical failures include, for example, a short circuit caused by foreign matter adhering to the light emitter and burned on the light emitter with heat generated by the light emitter. Optical failures include, for example, a decreased amount of light caused by foreign matter adhering to the light emitter and blocking light emitted from the light emitter.

The electrical and optical failures caused by foreign matter adhering to the light emitter are not limited to failures in the light irradiator used in a printing apparatus. These may occur in typical light irradiators used in other applications such as drying and curing of various objects under light irradiation.

A light source module including a light emitter and a light irradiator including the light source module can thus be improved to reduce foreign matter adhering to the light emitter while allowing electrical connection to the light emitter from outside the light source module. In other words, the light source module and the light irradiator can be improved to reduce foreign matter adhering to the light emitter while allowing electrical connection to the light emitter from outside the light source module.

The inventor of the present disclosure has developed a technique for the light source module and the light irradiator to reduce foreign matter adhering to the light emitter while allowing electrical connection to the light emitter from outside the light source module.

The technique will be described with reference to the drawings for various embodiments and various examples. In the drawings, the same reference numerals denote the same or similar components and functions. Such components will not be described repeatedly. The drawings are schematic.

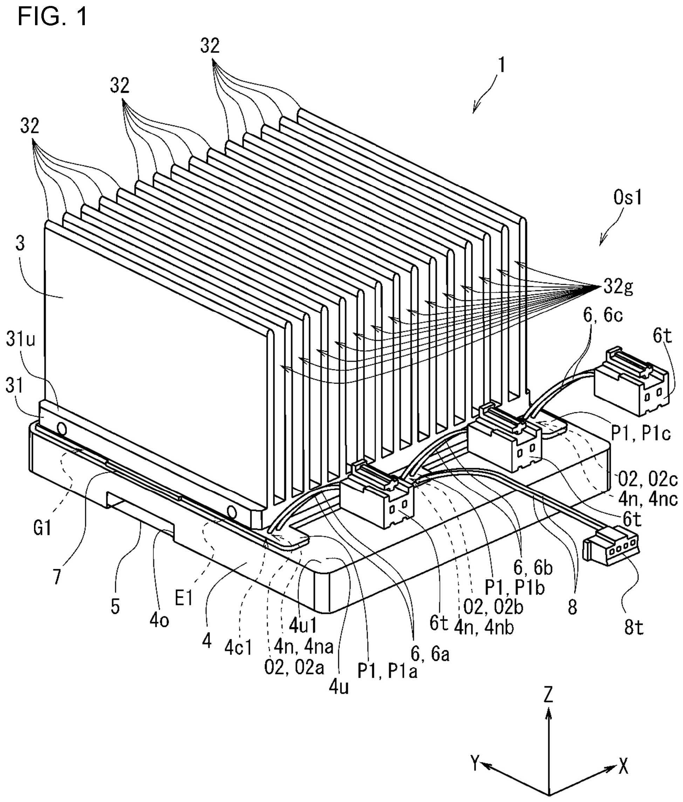

FIGs. 1 to 26 each illustrate a right-handed XYZ coordinate system. In the XYZ coordinate system, a direction in which a light source module 1 emits light (also referred to as an emission direction) is a negative Z-direction. A direction perpendicular to the negative Z-direction is a positive X-direction. A direction perpendicular to both the negative Z-direction and the positive X-direction is a positive Y-direction. Note that directional terms such as "up," "down," "right," and "left" in one or more embodiments of the present disclosure are simply used for clarity of explanation without limiting the structures and operating principles of the light source module 1 and a light irradiator 10.

### 1. First Embodiment

### 1-1. Light Source Module

The light source module 1 emits light. The light source module 1 is, for example, a module that emits light in a device (also referred to as a light irradiator) that irradiates an object (also referred to as an irradiation target) with light.

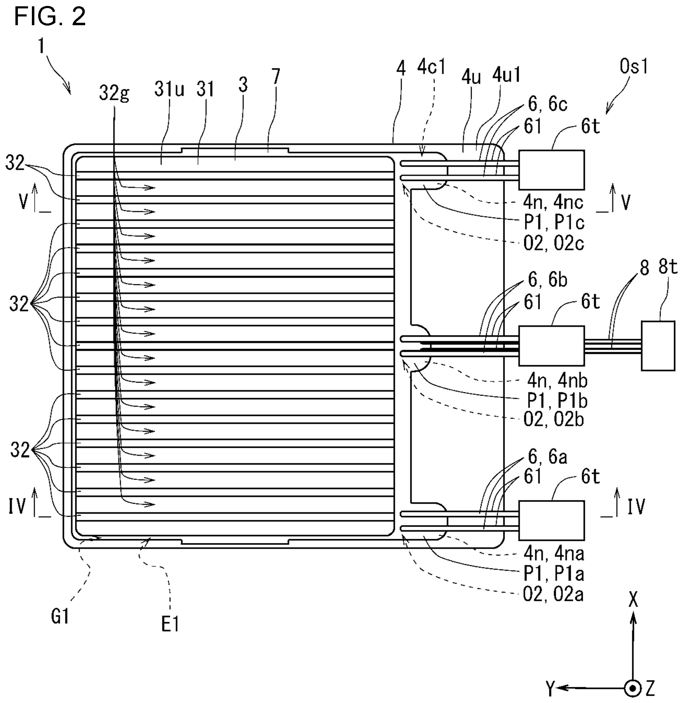

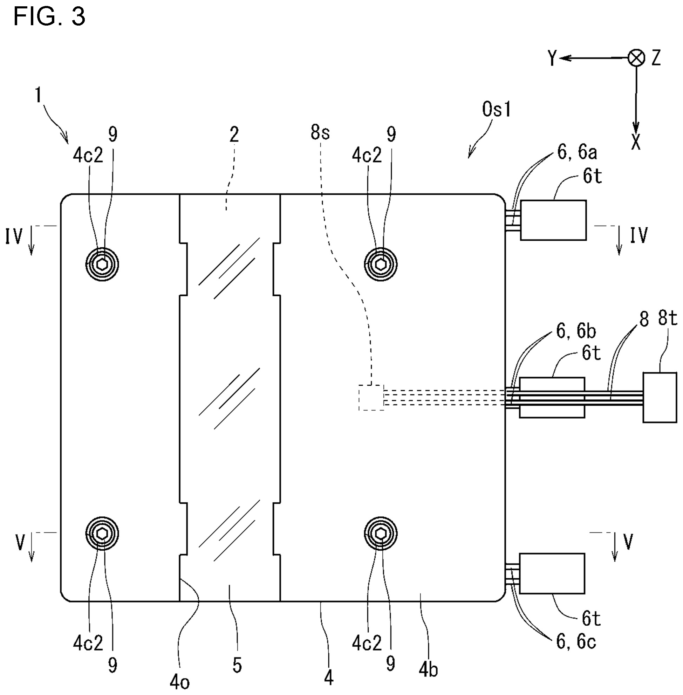

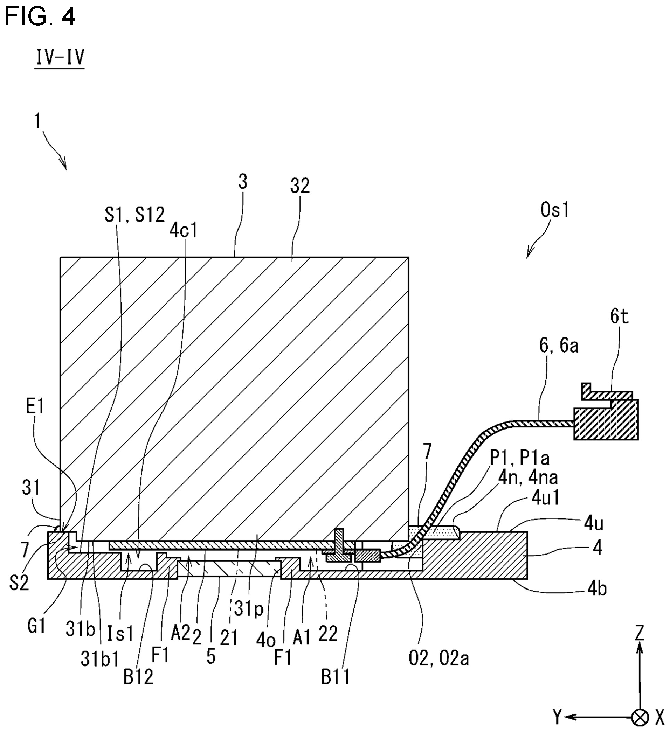

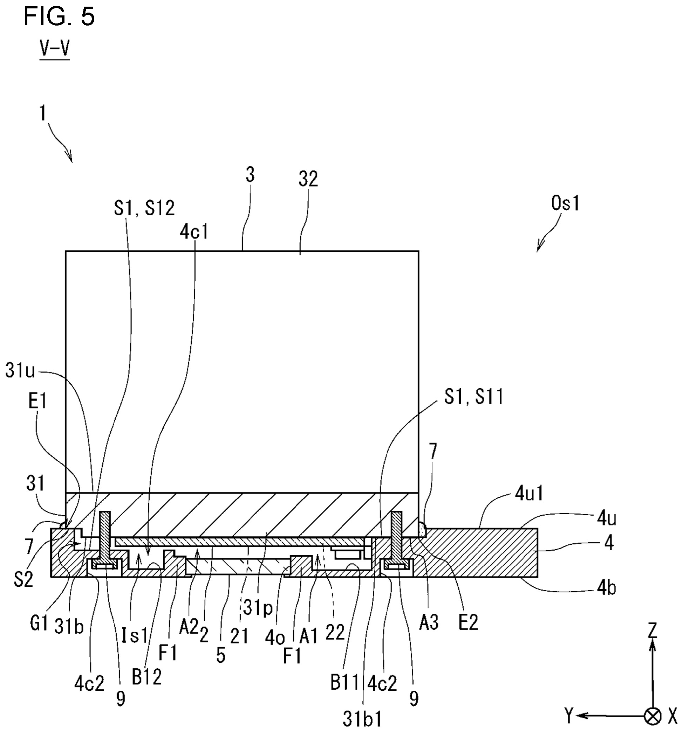

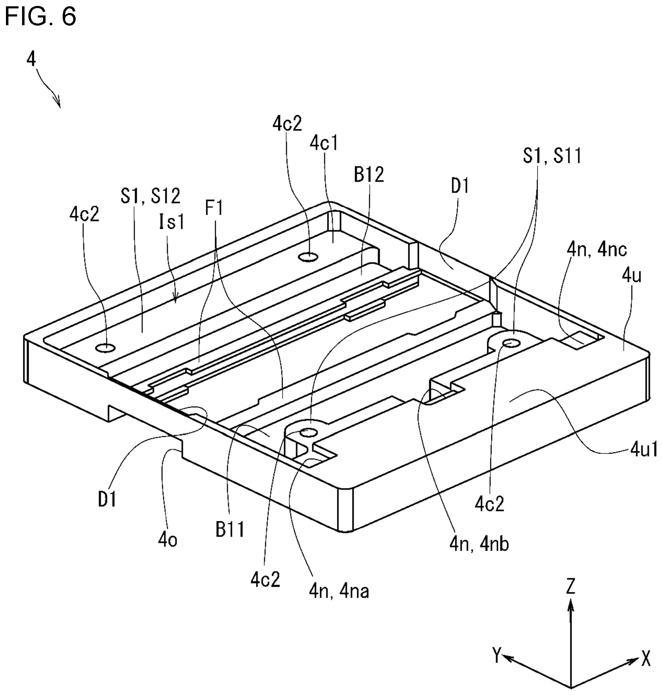

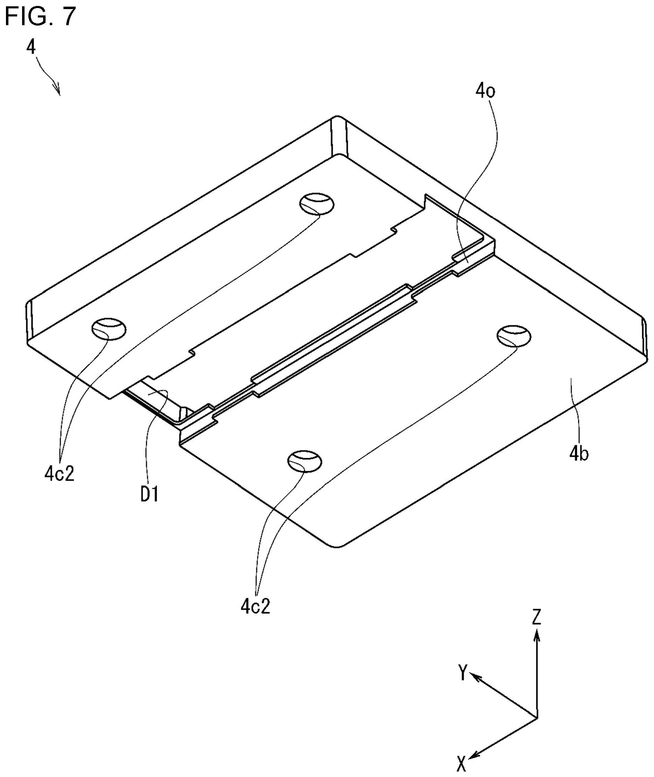

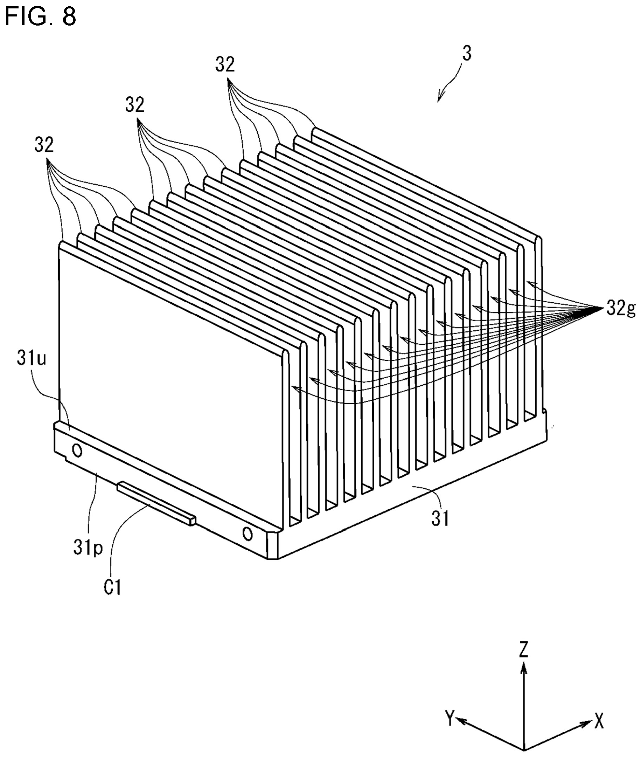

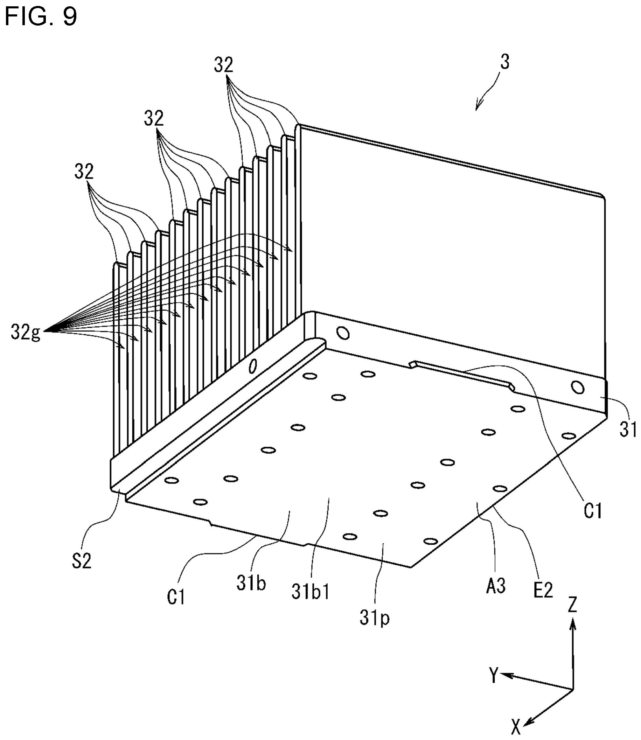

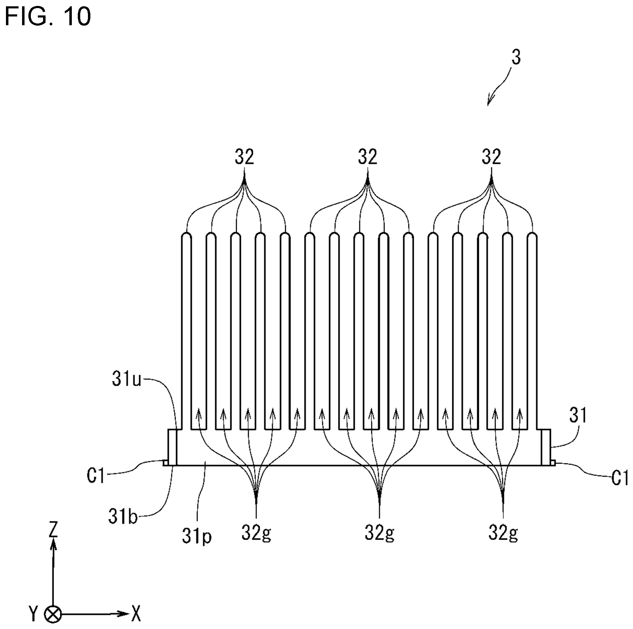

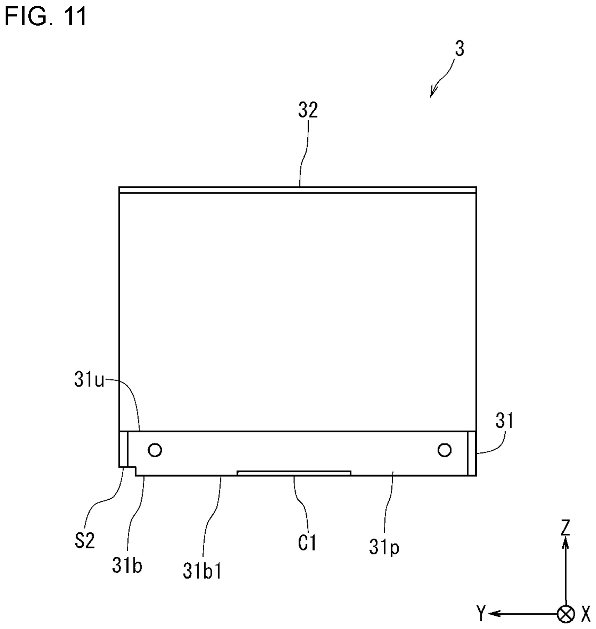

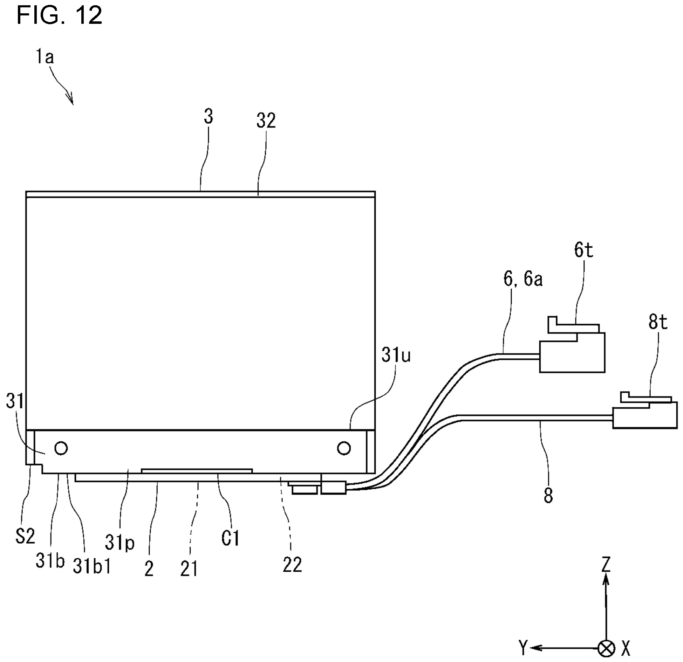

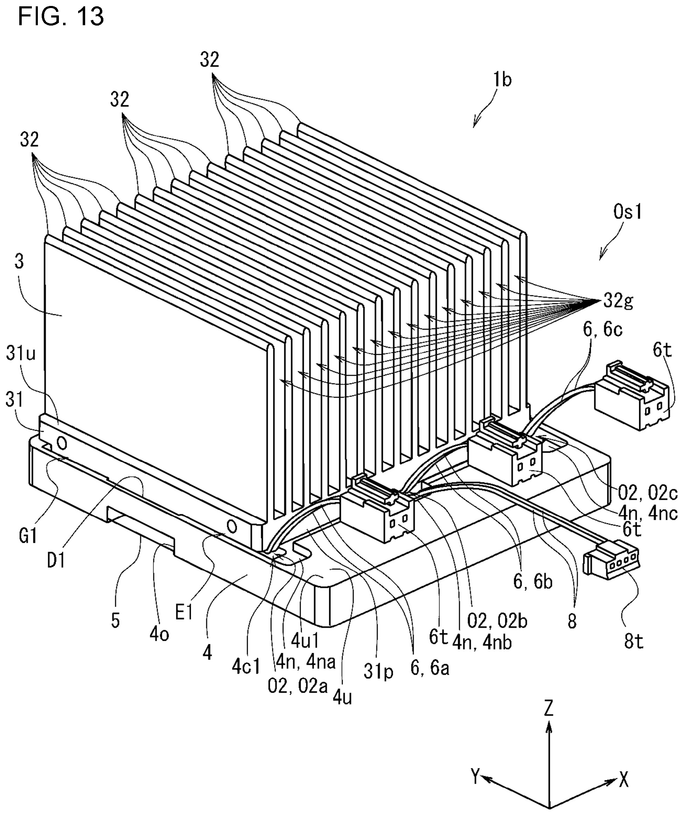

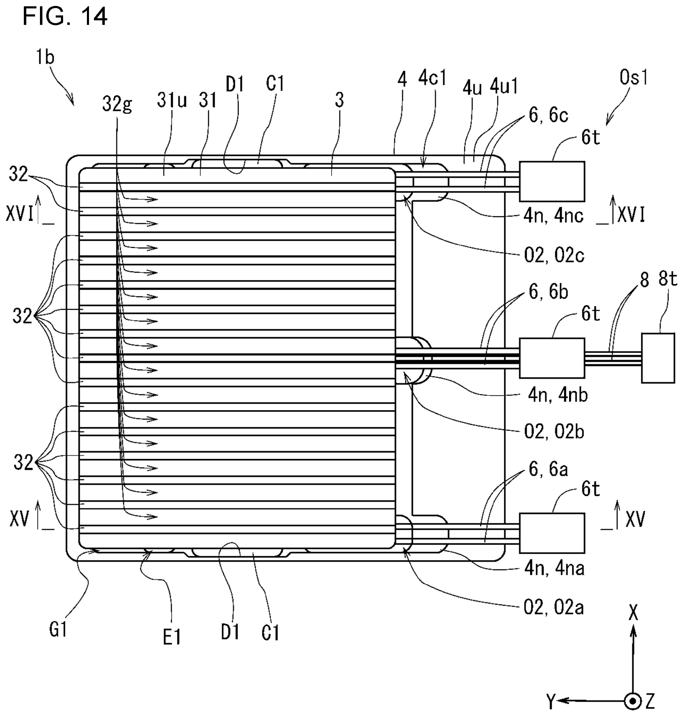

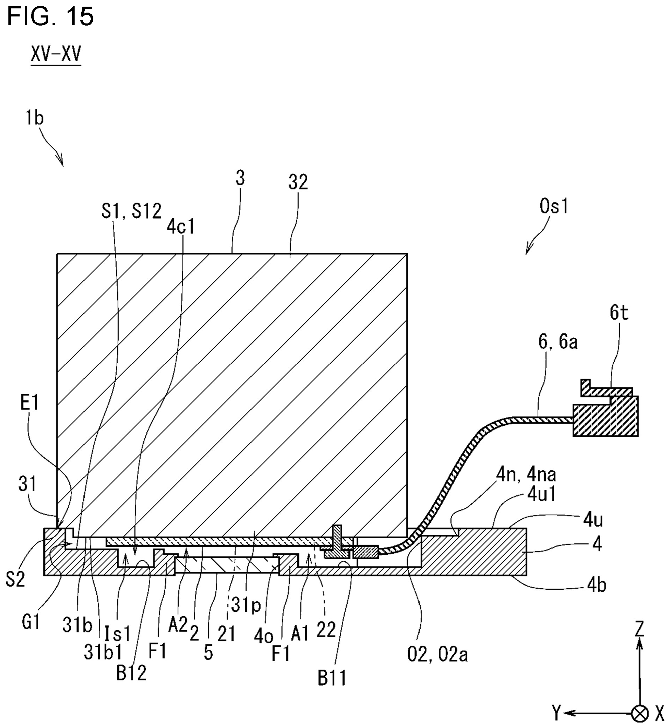

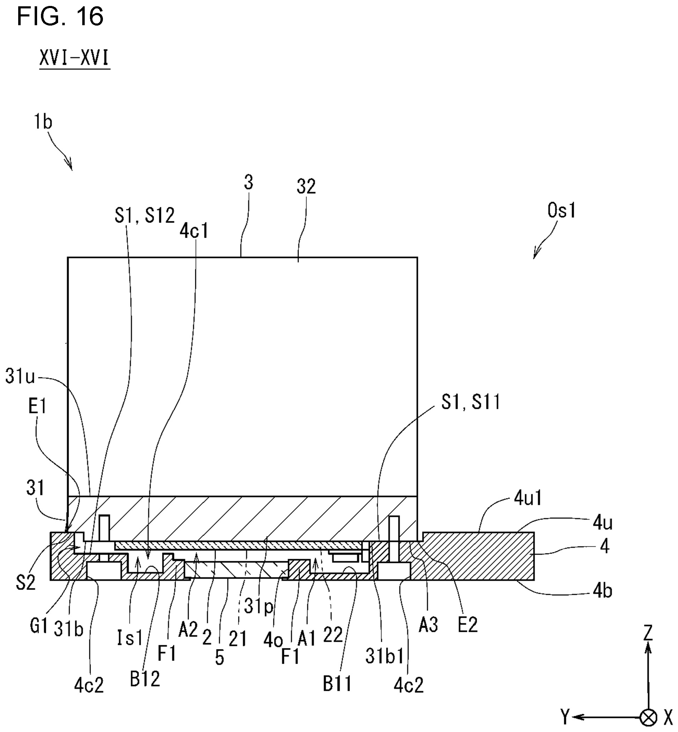

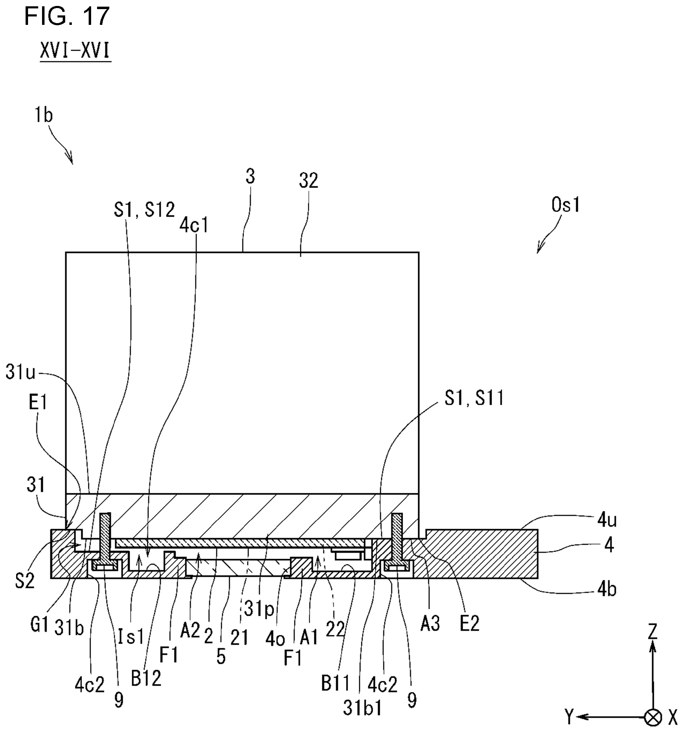

FIG. 1 is a perspective view of the light source module 1 according to a first embodiment, illustrating an example appearance. FIG. 2 is a plan view of the light source module 1 according to the first embodiment, illustrating an example appearance. FIG. 3 is a bottom view of the light source module 1 according to the first embodiment, illustrating an example appearance. FIG. 4 is a schematic cross-sectional view of the light source module 1 as viewed in the positive X-direction at position IV-IV in FIGs. 2 and 3, illustrating an example imaginary cross section of the light source module 1. FIG. 5 is a schematic cross-sectional view of the light source module 1 as viewed in the positive X-direction at position V-V in FIGs. 2 and 3, illustrating an example imaginary cross section of the light source module 1. FIG. 6 is a perspective view of a cover 4, illustrating an example appearance. FIG. 7 is a perspective view of the cover 4, illustrating an example appearance. FIG. 8 is a perspective view of a heat dissipator 3, illustrating an example appearance. FIG. 9 is a perspective view of the heat dissipator 3, illustrating an example appearance. FIG. 10 is a front view of the heat dissipator 3, illustrating an example appearance. FIG. 11 is a side view of the heat dissipator 3, illustrating an example appearance. FIG. 12 is a side view of a unit (also referred to as a first unit) 1a including a light emitter 2, a first cable 6, and a second cable 8 each attached to the heat dissipator 3, illustrating an example appearance. The first unit 1a includes the heat dissipator 3, and the light emitter 2, the first cable 6, and the second cable 8 each attached to the heat dissipator 3. FIG. 13 is a perspective view of a module (also referred to as a first module) 1b in which the heat dissipator 3 receiving the light emitter 2, the first cable 6, and the second cable 8 is mounted on the cover 4, illustrating an example appearance. The first module 1b includes the cover 4, the heat dissipator 3 on the cover 4, and the light emitter 2, the first cable 6, and the second cable 8 each attached to the heat dissipator 3. FIG. 14 is a plan view of the first module 1b, illustrating an example appearance. FIG. 15 is a schematic cross-sectional view of the first module 1b as viewed in the positive X-direction at position XV-XV in FIG. 14, illustrating an example imaginary cross section of the first module 1b. FIG. 16 is a schematic cross-sectional view of the first module 1b as viewed in the positive X-direction at position XVI-XVI in FIG. 14, illustrating an example imaginary cross section of the first module 1b. FIG. 17 is a schematic cross-sectional view of the first module 1b in FIG. 16 in an example state with the heat dissipator 3 and the cover 4 being fastened together with screws.

As illustrated in FIGs. 1 to 5, the light source module 1 includes the light emitter 2, the heat dissipator (heat sink) 3, the cover 4, a light-transmissive member 5, the first cable 6, and a sealant 7. In an example of the first embodiment, the light source module 1 includes the second cable 8, a sensor 8s, and a screw 9.

### 1-1-1. Heat Dissipator

The heat dissipator 3 dissipates heat generated from light emission of the light emitter 2. In other words, the heat dissipator 3 dissipates heat generated by the light emitter 2. The heat dissipator 3 is, for example, thermally connected to the light emitter 2. A first portion being thermally connected to a second portion indicates that heat is transferable between the first portion and the second portion. More specifically, the first portion being thermally connected to the second portion may indicate that heat is transferable between the first portion and the second portion directly or through one or more objects between the first portion and the second portion. The one or more objects may each be a highly thermally conductive object. The heat dissipator 3 is made of, for example, a highly thermally conductive metal, such as aluminum or copper. The heat dissipator 3 thermally connected to the light emitter 2 may include, in addition to the heat dissipator 3 directly connected to the light emitter 2, the heat dissipator 3 indirectly connected to the light emitter 2 with, for example, one or more highly thermally conductive members. In other words, the heat dissipator 3 thermally connected to the light emitter 2 may include the heat dissipator 3 directly connected to the light emitter 2 or the heat dissipator 3 indirectly connected to the light emitter 2 with, for example, the one or more highly thermally conductive members. In still other words, the heat dissipator 3 thermally connected to the light emitter 2 may include the heat dissipator 3 being in contact with the light emitter 2 to allow heat transfer between the heat dissipator 3 and the light emitter 2 or a structure in which the one or more objects between the heat dissipator 3 and the light emitter 2 allow heat transfer. The one or more objects may each be a highly thermally conductive object.

As illustrated in FIGs. 1, 2, 4, 5, and 8 to 11, the heat dissipator 3 includes a base 31 and multiple protrusions 32.

The base 31 is, for example, a plate or a rectangular prism. The base 31 includes a first surface 31b and a second surface 31u. The second surface 31u is opposite to the first surface 31b. For example, the base 31 as a plate includes end faces connecting the first surface 31b and the second surface 31u. For the base 31 as a plate, the thickness of the base 31 may be the length of the base 31 in a direction (emission direction) in which the light source module 1 emits light. The emission direction may be a direction parallel to, for example, the negative Z-direction.

The first surface 31b is a portion of the base 31 adjacent to the cover 4. In other words, the first surface 31b faces the cover 4. In still other words, the first surface 31b is a portion of the base 31 adjacent to the light emitter 2. The first surface 31b may be, for example, a substantially flat surface. More specifically, the first surface 31b may be, for example, a surface in an imaginary plane parallel to an XY plane. The first surface 31b may include an uneven portion or a step. The uneven portion or the step may be shaped based on, for example, the shape of the cover 4. In an example of the first embodiment, the first surface 31b includes a substantially flat reference portion (also referred to as a first reference portion) 31b1 within the first surface 31b and, at an end in the positive Y-direction, a stepped portion S2 extending in the positive X-direction as illustrated in FIGs. 4, 5, 9, and 11. The stepped portion S2 is closer to the second surface 31u than the first reference portion 31b1 is. In this example, the first surface 31b includes a step including the first reference portion 31b1 and the stepped portion S1. The base 31 may include, for example, an uneven portion on the first surface 31b to receive components, such as the light emitter 2 and the cover 4, attached to the heat dissipator 3. The uneven portion may include a screw hole. The screw hole may be open in the first surface 31b. The screw hole may be a cylindrical hole with an internal thread on its inner circumferential surface.

The second surface 31u may be, for example, a substantially flat surface. More specifically, the second surface 31u may be, for example, a surface in an imaginary plane parallel to the XY plane. The second surface 31u is not limited to a substantially flat surface, and may include an uneven portion or a step.

The first surface 31b and the second surface 31u may each be, for example, a surface with a rectangular outer edge as viewed in plan. In this case, the surface with a rectangular outer edge may be, for example, a surface with an outer edge that is rectangular and includes sides of about 50 to 90 mm long. The outer edge of each of the first surface 31b and the second surface 31u may include, for example, one pair of two sides facing each other and extending in the positive X-direction, and the other pair of two sides facing each other and extending in the positive Y-direction. The first surface 31b as viewed in plan may be the first surface 31b as viewed in a direction along a normal to the first surface 31b. The normal to the first surface 31b may be, for example, an imaginary line extending in the positive Z-direction. The second surface 31u as viewed in plan may be the second surface 31u as viewed in a direction along a normal to the second surface 31u. The normal to the second surface 31u may be, for example, an imaginary line extending in the negative Z-direction.

The multiple protrusions 32 each protrude from the base 31 in a direction away from the cover 4. In other words, the multiple protrusions 32 each protrude from the second surface 31u. The direction away from the cover 4 may be, for example, a direction perpendicular to the second surface 31u. The direction perpendicular to the second surface 31u may be, for example, the positive Z-direction. The multiple protrusions 32 define multiple clearances (also referred to as second clearances) 32g between the multiple protrusions 32. Each of the multiple protrusions 32 may be, for example, a thin plate. Two adjacent protrusions 32 of the multiple protrusions 32 are located with a second clearance 32g between them. The heat dissipator 3 may cool the light emitter 2 as heat transferred from the light emitter 2 to the heat dissipator 3 dissipates into air flowing through the multiple second clearances 32g between the multiple protrusions 32. The multiple protrusions 32 are a first predetermined number of protrusions 32 that are two or more protrusions 32. The first predetermined number is a natural number greater than or equal to 2. The multiple protrusions 32 may be arranged with, for example, a predetermined pitch in a first direction along the second surface 31u. The first direction may be, for example, a direction parallel to the positive X-direction. Each of the multiple protrusions 32 may be, for example, a thin plate (also referred to as a fin) extending along an imaginary plane perpendicular to the second surface 31u. The imaginary plane perpendicular to the second surface 31u may be a plane along an imaginary plane parallel to a YZ plane.

The heat dissipator 3 may be formed by, for example, cutting many grooves on a rectangular prism block made of a metal such as aluminum or copper. The heat dissipator 3 may be formed by, for example, attaching many thin plates made of a metal such as aluminum or copper to a flat plate made of a metal such as aluminum or copper.

### 1-1-2. Light Emitter

The light emitter 2 includes multiple light-emitting elements 21. As illustrated in FIGs. 4 and 5, the light emitter 2 is located between the first surface 31b of the base 31 of the heat dissipator 3 and the light-transmissive member 5. In other words, the light emitter 2 is located on the base 31 of the heat dissipator 3 at a position adjacent to the cover 4. More specifically, the light emitter 2 is located on the base 31 of the heat dissipator 3 at a position adjacent to a first opening (also referred to as a light-emission opening) 4o in the cover 4.

The light emitter 2 includes, for example, a substrate 22 and the multiple light-emitting elements 21. In this case, the multiple light-emitting elements 21 are arranged on the substrate 22.

The substrate 22 is a substrate (also referred to as a light emitter substrate) on which the multiple light-emitting elements 21 are arranged. The substrate 22 is, for example, a plate-like ceramic substrate (also referred to as a ceramic wiring board). A wiring conductor electrically connecting the inside and the outside of the substrate 22 is located on the surface of the substrate 22 and inside the substrate 22. The material of the wiring conductor is a conductive material such as tungsten, molybdenum, manganese, or copper. For the substrate 22 that is a ceramic wiring board, the base material of the ceramic wiring board is an insulating ceramic material. The ceramic wiring board is thus resistant to heat generated by the light emitter 2 integrating the multiple light-emitting elements 21.

The substrate 22 may be located on the base 31 of the heat dissipator 3 at a position adjacent to the light-emission opening 4o. The substrate 22 is, for example, a plate along the first surface 31b of the base 31. The substrate 22 may be, for example, fixed to the base 31. More specifically, the substrate 22 may be fixed on the first surface 31b of the base 31. The substrate 22 may be fixed to the base 31 by, for example, screwing. The base 31 and the substrate 22 may be in close contact with each other with thermal grease between the base 31 and the substrate 22. This may improve thermal connection between the light emitter 2 and the heat dissipator 3. Heat from the light emitter 2 may thus be more efficiently dissipated with the heat dissipator 3. The substrate 22 may be fixed to the base 31 with, for example, a highly thermally conductive metal member.

Each of the multiple light-emitting elements 21 is, for example, a light-emitting diode (LED) element. The light-emitting element 21 may be of any type selected as appropriate for the wavelength of light emitted from the light-emitting element 21. For example, the LED element may be a gallium nitride (GaN) LED that emits ultraviolet light, or a gallium arsenide (GaAs) LED that emits infrared light. For example, the multiple light-emitting elements 21 may be aligned in a row or in a matrix of multiple rows on the substrate 22.

The light emitter 2 may include two or more substrates 22 aligned along the first surface 31b of the base 31. In the light emitter 2 including two or more substrates 22, two or more light-emitting elements 21 may be arranged on each of the substrates 22.

### 1-1-3. First Cable

The first cable 6 is electrically connected to the light emitter 2. The first cable 6 is used to supply power for light emission of the multiple light-emitting elements 21.

The first cable 6 may be, for example, a linear component (also referred to as a first linear component) including one or more layers of insulating coatings covering multiple electric wires (also referred to as insulated wires) each including a linear conductor covered with an insulating protective film. The first cable 6 is not limited to the first linear component. The first cable 6 may be, for example, a linear component (also referred to as a second linear component) including a linear conductor covered with one or more layers of insulating coatings. The first cable 6 may be multiple second linear components separate from one another. In other words, the first cable 6 may include multiple second linear components.

For example, the first cable 6 includes a first end and a second end in pairs in a longitudinal direction. In other words, for example, the first end is one end in the longitudinal direction of the first cable 6, and the second end is the other end opposite to the first end in the longitudinal direction of the first cable 6. A connector (also referred to as a first connector) 6t may be attached to, for example, the first end of the first cable 6. The first connector 6t may be a plug connector or a socket connector. In an example of the first embodiment, as illustrated in FIGs. 1 to 3, the first cable 6 includes the first end including the ends of two linear components each attached to a single first connector 6t. The single first connector 6t is a plug connector.

The first cable 6 may be, for example, electrically connected to the substrate 22. More specifically, the second end of the first cable 6 may be electrically connected to the wiring conductor on the substrate 22. The second end may be electrically connected to the wiring conductor with, for example, connection using a member such as a crimp terminal or by bonding such as soldering.

The light source module 1 may include one first cable 6 or two or more first cables 6. For example, the number of first cables 6 may be any number corresponding to the number and the structure of the substrates 22 in the light emitter 2. For example, the light source module 1 may include a second predetermined number of first cables 6 when the light emitter 2 includes the second predetermined number of substrates 22. The second predetermined number is a natural number greater than or equal to 1. The second predetermined number may be, for example, 2 or 3. In an example of the first embodiment, the light source module 1 includes three first cables 6 as illustrated in FIGs. 1 to 3. The three first cables 6 include a first A-cable 6a, a first B-cable 6b, and a first C-cable 6c.

### 1-1-4. Cover

The cover 4 covers the light emitter 2. For example, the cover 4 may include an outer edge located outward from the outer edge of the base 31 of the heat dissipator 3 when the cover 4 and the heat dissipator 3 are viewed in plan as illustrated in FIG. 2. In other words, the cover 4 may cover the first surface 31b of the base 31. The cover 4 and the heat dissipator 3 as viewed in plan may be the cover 4 and the heat dissipator 3 as viewed along, for example, a normal to the second surface 31u. The normal to the second surface 31u may be, for example, an imaginary line extending in the negative Z-direction. The cover 4 may be made of, for example, a metal such as aluminum or another material such as plastic.

As illustrated in FIGs. 1, 3, and 4 to 7, the cover 4 includes the light-emission opening 4o. The cover 4 is attached to the heat dissipator 3. In other words, the cover 4 may be fixed to the heat dissipator 3. The cover 4 may be attached to the heat dissipator 3 with, for example, the sealant 7 and the screw 9.

The cover 4 may be, for example, a plate. The cover 4 includes a third surface 4u and a fourth surface 4b. The fourth surface 4b is opposite to the third surface 4u. The cover 4 that is a plate allows the multiple light-emitting elements 21 to be, for example, closer to an irradiation target. For the cover 4 that is a plate, the thickness of the cover 4 may be a length of the cover 4 in the direction (emission direction) in which the light source module 1 emits light.

The third surface 4u is a portion of the cover 4 adjacent to the heat dissipator 3. In other words, the third surface 4u faces the heat dissipator 3. The cover 4 includes a receding portion 4c1 on the third surface 4u. In other words, the third surface 4u including the receding portion 4c1 is a surface including an uneven portion. The receding portion 4c1 may be a portion of the cover 4 on the third surface 4u receding in a direction from the heat dissipator 3 to the light emitter 2 (also referred to as a receding direction). The receding direction may be, for example, the direction in which the light source module 1 emits light (also referred to as the emission direction). The emission direction may be, for example, a direction parallel to the negative Z-direction. In other words, the receding direction may be, for example, a direction parallel to the negative Z-direction.

The receding portion 4c1 may include, for example, an uneven portion within the receding portion 4c1. For example, the receding portion 4c1 may include one or more stepped portions S1 (also referred to as steps) each located in at least a part of an outer peripheral portion of the receding portion 4c1. The outer peripheral portion of the receding portion 4c1 may extend along a peripheral edge of the receding portion 4c1 as viewed in plan in the receding direction in a transparent manner. The peripheral edge of the receding portion 4c1 may be, for example, an outer edge of the receding portion 4c1 or an edge along the outer periphery of the receding portion 4c1. The receding portion 4c1 receding in the receding direction has a depth referred to as a receding depth, with a portion (also referred to as a second reference portion) 4u1 of the third surface 4u other than the receding portion 4c1 serving as a reference. The second reference portion 4u1 may be, for example, a substantially flat surface. More specifically, the second reference portion 4u1 may be, for example, a surface in an imaginary plane parallel to the XY plane. The stepped portion S1 may have an intermediate receding depth in a portion receding deeper in steps in, for example, a direction from the peripheral edge of the receding portion 4c1 to inside the receding portion 4c1. The direction from the peripheral edge of the receding portion 4c1 to inside the receding portion 4c1 may be, for example, a direction from the peripheral edge of the receding portion 4c1 to the center of the receding portion 4c1 as viewed in plan in the receding direction in a transparent manner. The center of the receding portion 4c1 may be, for example, the center of the receding portion 4c1 as viewed in plan in the receding direction in a transparent manner. The center may be, for example, the center of gravity. In other words, the stepped portion S1 may have an intermediate receding depth in a portion of the third surface 4u receding deeper in steps at positions from the second reference portion 4u1 to the center of the receding portion 4c1.

In an example of the first embodiment, as illustrated in FIGs. 4 to 6, the receding portion 4c1 includes a portion of the third surface 4u receding deeper in two steps at positions from the second reference portion 4u1 to the center of the receding portion 4c1. More specifically, the receding portion 4c1 includes, in a portion at an end of the receding portion 4c1 in the negative Y-direction, a portion receding deeper in two steps at positions in the positive Y-direction from the second reference portion 4u1. The portion includes a first stepped portion S1 (also referred to as a first stepped portion S11 or a first step) and a first bottom portion B11 receding deeper than the first stepped portion S11. The receding portion 4c1 includes two first stepped portions S11. The receding portion 4c1 also includes, in a portion at an end of the receding portion 4c1 in the positive Y-direction, a portion receding deeper in two steps at positions in the negative Y-direction from the second reference portion 4u1. The portion includes a second stepped portion S1 (also referred to as a second stepped portion S12 or a second step) and a second bottom portion B12 receding deeper than the second stepped portion S12. The receding portion 4c1 includes one second stepped portion S12. The receding portion 4c1 is not limited to a structure including two first stepped portions S11. For example, the receding portion 4c1 may include one first stepped portion S11 or three or more first stepped portions S11. In other words, the receding portion 4c1 may include, for example, one or more first stepped portions S11 each located in at least a part of the outer peripheral portion of the receding portion 4c1. The receding portion 4c1 is not limited to a structure including one second stepped portion S12. For example, the receding portion 4c1 may include two second stepped portions S12 or three or more second stepped portions S12. In other words, the receding portion 4c1 may include, for example, one or more second stepped portions S12 each located in at least a part of the outer peripheral portion of the receding portion 4c1.

At least a part of an area (also referred to as an outer peripheral area) A3 in the first surface 31b of the base 31 along an outer edge E2 of the first surface 31b is in contact with the third surface 4u. For example, at least a part of the outer peripheral area A3 may be in contact with the outer peripheral portion of the receding portion 4c1 of the third surface 4u. For example, at least a part of the outer peripheral area A3 may be in contact with at least one stepped portion S1 of the one or more stepped portions S1. More specifically, at least a part of the outer peripheral area A3 on the first surface 31b of the base 31 may be in contact with each of the one or more first stepped portions S11. In an example of the first embodiment, a part of the outer peripheral area A3 in the first surface 31b of the base 31 is in contact with each of the one or more first stepped portions S11 as illustrated in FIG. 5. More specifically, a portion at an end of the outer peripheral area A3 in the negative Y-direction is in contact with the two first stepped portions S11. The stepped portion S2 at an end of the outer peripheral area A3 in the positive Y-direction is in contact with the second reference portion 4u1 of the third surface 4u.

The fourth surface 4b may be, for example, a substantially flat surface. More specifically, the fourth surface 4b may be, for example, a surface in an imaginary plane parallel to the XY plane. The cover 4 and the light-transmissive member 5 may thus be still closer to the irradiation target. In other words, the multiple light-emitting elements 21 may be still closer to the irradiation target. The fourth surface 4b may be, for example, a surface with a rectangular outer edge as viewed in plan. In this case, the surface with a rectangular outer edge may be, for example, a surface with an outer edge that is rectangular and includes sides of about 60 to 100 mm long. The rectangular outer edge of the fourth surface 4b may include, for example, one pair of two sides facing each other and extending in the positive X-direction and the other pair of two sides facing each other and extending in the positive Y-direction. The fourth surface 4b as viewed in plan may be the fourth surface 4b as viewed in a direction along a normal to the fourth surface 4b. The normal to the fourth surface 4b may be, for example, an imaginary line in the positive Z-direction.

The light-emission opening 4o is an opening through which light from the light emitter 2 passes. The light-emission opening 4o is open in the receding portion 4c1. The light-emission opening 4o extends through the cover 4 from the third surface 4u to the fourth surface 4b. The light-emission opening 4o may be open in, for example, a central portion of the fourth surface 4b including the center point of the fourth surface 4b or at a position shifted from the center point of the fourth surface 4b. The light-emission opening 4o may have a shape or a size set as appropriate for the use of the light source module 1. In other words, the light-emission opening 4o may be shaped based on the positions of the multiple light-emitting elements 21 in the light emitter 2. In other words, the light-emission opening 4o may be located in an area of the cover 4 corresponding to an area of the light emitter 2 including the multiple light-emitting elements 21.

In an example of the first embodiment, the light-emission opening 4o extends from one end (also referred to as a first end) of the fourth surface 4b to the other end (also referred to as a second end) opposite to the first end in one direction along the fourth surface 4b as illustrated in FIGs. 3, 6, and 7. The one direction may be, for example, a direction parallel to the positive X-direction as the first direction. The first end may be an end of the fourth surface 4b in the negative X-direction. The second end may be an end of the fourth surface 4b in the positive X-direction. In other words, the fourth surface 4b includes the first end and the second end in pairs in the positive X-direction as the first direction. In the fourth surface 4b as viewed in plan, for example, the light-emission opening 4o is shaped as a rectangle having a longitudinal direction parallel to the positive X-direction as the first direction and a lateral direction parallel to the positive Y-direction as a second direction.

The cover 4 may include, for example, holders F1 extending along the light-emission opening 4o. The holders F1 hold the light-transmissive member 5. In an example of the first embodiment, the holders F1 are located with the light-emission opening 4o between the holders F1 in the lateral direction of the light-emission opening 4o as illustrated in FIGs. 4 to 7. The receding portion 4c1 with the holders F1 may include, for example, a portion (also referred to as a projecting portion) projecting toward the heat dissipator 3 along the light-emission opening 4o.

As illustrated in FIGs. 4 and 5, the receding portion 4c1 includes a space (also referred to as an internal space) Is1 in the receding portion 4c1. The internal space Is1 is surrounded by the receding portion 4c1. More specifically, the internal space Is1 may be surrounded by, for example, an imaginary plane along the second reference portion 4u1 of the third surface 4u and the receding portion 4c1. The internal space Is1 receives a portion (also referred to as a receivable portion) 31p of the base 31 of the heat dissipator 3. The receivable portion 31p is a portion of the base 31 placed in the internal space Is1 in the receding portion 4c1. The receivable portion 31p may be a portion of the base 31 adjacent to the first surface 31b. In an example of the first embodiment, the receivable portion 31p is a portion of the base 31 along the first reference portion 31b1 of the first surface 31b as illustrated in FIGs. 4 and 5. For example, the receivable portion 31p including a portion fittable to a part of the receding portion 4c1 may allow easier alignment of the heat dissipator 3 and the cover 4 during the manufacture of the light source module 1. In an example of the first embodiment, two projections C1 each as a part of the receivable portion 31p are fittable to two recesses D1 on the inner circumferential surface of the receding portion 4c1 of the cover 4 as illustrated in FIGs. 6 to 14. The two projections C1 include a projection C1 projecting in the positive X-direction from the base 31 in the positive X-direction, and a projection C1 projecting in the negative X-direction from the base 31 in the negative X-direction. The two recesses D1 include a recess D1 receding in the positive X-direction in a portion of the inner circumferential surface of the receding portion 4c1 in the positive X-direction, and a recess D1 receding in the negative X-direction in a portion of the inner circumferential surface of the receding portion 4c1 in the negative X-direction.

As illustrated in FIGs. 4 and 5, the internal space Is1 includes an area (also referred to as a first area) A1 between the cover 4 and the first surface 31b of the base 31. In other words, the first area A1 is a spatial area between the cover 4 and the first surface 31b of the base 31. The first area A1 may include, for example, the light emitter 2. The first area A1 may include, for example, a portion of the first cable 6 adjacent to the second end. The light emitter 2 may not be in contact with the cover 4. The light emitter 2 is thus less likely to be damaged by collision between the light emitter 2 and the cover 4 during, for example, the manufacture of the light source module 1. The light emitter 2 is also less likely to be, for example, an obstacle for alignment of the heat dissipator 3 and the cover 4.

As illustrated in FIGs. 13 to 17, the base 31 has a profile along, for example, the peripheral edge of the receding portion 4c1. The heat dissipator 3 and the cover 4 may include a clearance (also referred to as a first clearance) G1 between the heat dissipator 3 and the cover 4. More specifically, the first clearance G1 may extend between the base 31 of the heat dissipator 3 and the cover 4. For example, the first clearance G1 with a sufficient size reduces stress between the heat dissipator 3 and the cover 4 resulting from the difference in thermal expansion between the heat dissipator 3 and the cover 4.

As illustrated in FIGs. 4 and 13 to 15, an opening (also referred to as a second opening) O2 receiving the first cable 6 is between the receding portion 4c1 and the base 31. The second opening O2 connects to the first area A1. More specifically, the first cable 6 may extend from inside the first area A1 to an outside Os1 of the receding portion 4c1 through the second opening O2. In other words, the second opening O2 may receive the first cable 6 extending from inside the first area A1 to the outside Os1 of the receding portion 4c1. The outside Os1 is a space that is not surrounded by the receding portion 4c1. In other words, the outside Os1 is a space outward from the internal space Is1. A portion of the first cable 6 adjacent to the first end is in the outside Os1. The portion of the first cable 6 adjacent to the first end may be exposed outside the light source module 1.

The second opening O2 may be, for example, an expanding part of the first clearance G1 between the heat dissipator 3 and the cover 4. As illustrated in FIGs. 13 to 15, the second opening O2 is between the receding portion 4c1 and the base 31 with the receding portion 4c1 including, for example, a portion (also referred to as a first extension) 4n extending in a direction toward outside the receding portion 4c1 in the outer peripheral portion of the receding portion 4c1. The direction toward outside the receding portion 4c1 may be, for example, a direction away from the center of the receding portion 4c1 as viewed in plan in the receding direction in a transparent manner. The first extension 4n of the receding portion 4c1 may be, for example, a notch in the outer peripheral portion of the receding portion 4c1.

The first extension 4n of the receding portion 4c1 may recede deeper in steps or continuously in, for example, a direction from the peripheral edge of the receding portion 4c1 to inside the receding portion 4c1. This allows, for example, easier placement of the first cable 6 extending from inside the first area A1 to the outside Os1 of the receding portion 4c1 through the second opening O2. This also allows, for example, easier placement of the sealant 7 covering the second opening O2. In an example of the first embodiment, the first extension 4n of the receding portion 4c1 recedes deeper in two steps at positions from the second reference portion 4u1 to the center of the receding portion 4c1 on the third surface 4u as illustrated in FIGs. 13 to 15. More specifically, the first extension 4n of the receding portion 4c1 in a portion at an end of the receding portion 4c1 in the negative Y-direction recedes deeper in two steps at positions in the positive Y-direction from the second reference portion 4u1. A portion of the first extension 4n of the receding portion 4c1 having an intermediate receding depth may be flush with the stepped portion S1 of the receding portion 4c1. More specifically, the portion of the first extension 4n of the receding portion 4c1 having an intermediate receding depth may be flush with the first stepped portion S11. The receding portion 4c1 may thus be formed easily, for example.

The light source module 1 may include one second opening O2 or two or more second openings O2. For example, the number of second openings O2 may correspond to the number of first cables 6. The light source module 1 including, for example, a third predetermined number of first cables 6 may include the third predetermined number of second openings O2. The third predetermined number is a natural number greater than or equal to 1. The third predetermined number may be, for example, 2 or 3. The receding portion 4c1 may include one first extension 4n or two or more first extensions 4n. For example, the number of first extensions 4n may correspond to the number of second openings O2. The light source module 1 including, for example, the third predetermined number of second openings O2 may include the receding portion 4c1 with the third predetermined number of first extensions 4n.

In an example of the first embodiment, the light source module 1 includes three first cables 6 and three second openings O2 each receiving the corresponding one of the first cables 6 as illustrated in FIGs. 1, 2, 13, and 14. The three second openings O2 include a second A-opening O2a, a second B-opening O2b, and a second C-opening O2c. The second A-opening O2a receives a first A-cable 6a. The second B-opening O2b receives a first B-cable 6b. The second C-opening O2c receives a first C-cable 6c. The receding portion 4c1 includes three first extensions 4n. The three first extensions 4n include a first A-extension 4na, a first B-extension 4nb, and a first C-extension 4nc. The first A-extension 4na defines the second A-opening O2a. The first B-extension 4nb defines the second B-opening O2b. The first C-extension 4nc defines the second C-opening O2c.

The cover 4 may include, for example, a through-hole 4c2 receiving the screw 9. The through-hole 4c2 extends through the fourth surface 4b to the third surface 4u. The through-hole 4c2 may have a shape of, for example, a cylindrical portion having a first diameter (also referred to as a smaller diameter portion) adjacent to the third surface 4u joined to a cylindrical portion having a second diameter larger than the first diameter (also referred to as a larger diameter portion) adjacent to the fourth surface 4b. The joint of the smaller diameter portion and the larger diameter portion may include an annular surface (also referred to as a receiving surface). The smaller diameter portion of the through-hole 4c2 may receive a shank of the screw 9. The larger diameter portion of the through-hole 4c2 may receive a head of the screw 9 with the head being in contact with the receiving surface of the through-hole 4c2. In this structure, the head of the screw 9 does not project from the fourth surface 4b. The cover 4 and the light-transmissive member 5 may be closer to the irradiation target. In other words, the multiple light-emitting elements 21 may be still closer to the irradiation target. The through-hole 4c2 may be open in, for example, the stepped portion S1 of the receding portion 4c1. Although the cover 4 may include the larger diameter portion in the back of the stepped portion S1, the cover 4 with this structure is less likely to be thicker.

The cover 4 may include one through-hole 4c2 or two or more through-holes 4c2. For example, the through-holes 4c2 may be as many as the screws 9. In an example of the first embodiment, the cover 4 includes four through-holes 4c2 as illustrated in FIGs. 3, 6, and 7. The four through-holes 4c2 include two through-holes 4c2 open in two first stepped portions S11 and two through-holes 4c2 open in the second stepped portion S12. The two first stepped portions S11 each include a single through-hole 4c2.

The cover 4 made of, for example, a metal may be produced by performing various processes on a rectangular prism block of a metal, such as aluminum. The various processes include, for example, cutting and punching. The cover 4 made of, for example, plastic may be produced by, for example, resin molding.

### 1-1-5. Light-Transmissive Member

The light-transmissive member 5 covers the light-emission opening 4o. The light-transmissive member 5 transmits light from the light emitter 2. The light-transmissive member 5 may be made of, for example, glass or heat-resistant plastic. The light-transmissive member 5 may be held by, for example, the holders F1 located along the light-emission opening 4o. The holders F1 may include, for example, tabs for holding the light-transmissive member 5. The light-transmissive member 5 may be attached to the holders F1 with, for example, an adhesive. In this case, the holders F1 hold the light-transmissive member 5 with the adhesive between the holders F1 and the light-transmissive member 5.

The light-transmissive member 5 may be shaped based on, for example, the shape of the light-emission opening 4o. The light-transmissive member 5 is, for example, a plate. In an example of the first embodiment, the light-emission opening 4o is rectangular and the light-transmissive member 5 is rectangular as illustrated in FIGs. 1 and 3 to 5 when the fourth surface 4b is viewed in plan. More specifically, the light-transmissive member 5 is a rectangular prism plate including, for example, a surface facing the light emitter 2 (also referred to as a fifth surface) and a surface facing opposite to the fifth surface (also referred to as a sixth surface). The light-transmissive member 5 is not limited to a plate. For example, at least one of the fifth surface or the sixth surface may be curved. This may adjust the divergence angle of light from the light emitter 2.

The light-transmissive member 5 may not be in contact with the light emitter 2. A spatial area (also referred to as a second area) A2 may extend between the light emitter 2 and the light-transmissive member 5. The second area A2 may be connected to the first area A1. For example, the light-transmissive member 5 not in contact with the light emitter 2 reduces damage to the light emitter 2 resulting from collision between the light emitter 2 and the light-transmissive member 5 during the manufacture of the light source module 1. This structure also reduces, for example, failures caused by the light emitter 2 and the light-transmissive member 5 being in contact with each other and obstructing the alignment between the heat dissipator 3 and the cover 4.

### 1-1-6. Sealant

As illustrated in FIGs. 1, 2, 4, and 5, the sealant 7 covers the first clearance G1 between the heat dissipator 3 and the cover 4 along a peripheral edge E1 of the first clearance G1. The peripheral edge E1 of the first clearance G1 may be, for example, an edge (also referred to as an outer edge) outside the first clearance G1 or an edge along the outer periphery of the first clearance G1. The sealant 7 includes a portion (also referred to as a first portion) P1 covering the second opening O2 with the first cable 6 extending through the portion. In other words, the first cable 6 extends through the sealant 7 that covers the second opening O2. The sealant 7 is made of a resin. The first cable 6 thus allows electrical connection from outside the light source module 1 to the light emitter 2. The sealant 7 covering the first clearance G1 and the second opening O2 reduces foreign matter entering the light emitter 2 from outside the light source module 1. This structure allows electrical connection from outside the light source module 1 to the light emitter 2 and may reduce foreign matter adhering to the light emitter 2.

In this example, the sealant 7 may be loop-shaped along the peripheral edge E1 of the first clearance G1. In an example of the first embodiment, the sealant 7 is quadrangular loop-shaped along the peripheral edge E1 of the first clearance G1 as illustrated in FIGs. 1, 2, and 4.

For example, the sealant 7 along the peripheral edge E1 of the first clearance G1 may or may not extend to the first surface 31b in the internal space Is1 in the receding portion 4c1, except the sealant 7 along the second opening O2. In other words, for example, the sealant 7 may include a first portion P1 extending onto the first surface 31b in the internal space Is1 in the receding portion 4c1. The sealant 7 may thus seal the second opening O2 more tightly.

The sealant 7 may include any number of first portions P1 based on the number of second openings O2. In the light source module 1 including a fourth predetermined number of second openings O2, for example, the sealant 7 may include the fourth predetermined number of first portions P1. The fourth predetermined number is a natural number greater than or equal to 1. The fourth predetermined number may be, for example, 2 or 3.

In an example of the first embodiment, as illustrated in FIGs. 1 and 2, the light source module 1 includes three second openings O2, and the sealant 7 includes three first portions P1. The three first portions P1 include a first A-portion P1a, a first B-portion P1b, and a first C-portion P1c. The first A-portion P1a covers the second A-opening O2a with the first A-cable 6a extending through the first A-portion P1a. The first B-portion P1b covers the second B-opening O2b with the first B-cable 6b extending through the first B-portion P1b. The first C-portion P1c covers the second C-opening O2c with the first C-cable 6c extending through the first C-portion P1c. In other words, the first A-cable 6a extends through the sealant 7 that covers the second A-opening O2a. The first B-cable 6b extends through the sealant 7 that covers the second B-opening O2b. The first C-cable 6c extends through the sealant 7 that covers the second C-opening O2c.

In an example of the first embodiment, the first B-portion P1b covers the second B-opening O2b with the second cable 8 extending through the first B-portion Pb1 as illustrated in FIGs. 1 to 3. In other words, the second cable 8 extends through the sealant 7 that covers the second B-opening O2b. In other words, the first B-portion P1b covers the second B-opening O2b with the first B-cable 6b and the second cable 8 extending through the first B-portion P1b. In other words, the first B-cable 6b and the second cable 8 extend through the sealant 7 that covers the second B-opening O2b. In this example, the second cable 8 extends from the first area A1 to the outside Os1 of the receding portion 4c1 through the second B-opening O2b. In other words, the second B-opening O2b may receive the second cable 8 extending from inside the first area A1 to the outside Os1 of the receding portion 4c1.

Commonly used LED packages include light-emitting elements directly covered with a protective resin to protect the light-emitting elements. However, the light emitter 2 including, for example, no sealant 7 in the second area A2 between the light emitter 2 and the light-transmissive member 5 and no resin around the multiple light-emitting elements 21 is likely to include densely aligned multiple light-emitting elements 21 easily. For example, no protective resin between the multiple light-emitting elements 21 and the light-transmissive member 5 may reduce attenuation of the amount of light from the multiple light-emitting elements 21 traveling toward outside the light source module 1 through the light-transmissive member 5. This may increase the amount of light emitted from the light source module 1. This can also reduce, for example, deterioration of a protective resin caused by the heat generated by light emission of the multiple light-emitting elements 21 or light from the multiple light-emitting elements 21.

For example, the resin forming the sealant 7 is elastic. Such elasticity may be a typical property of the resin. The elastic resin is, for example, an adhesive with elasticity, such as a silicone adhesive. For example, a silicone adhesive may be placed along the peripheral edge E1 of the first clearance G1 between the heat dissipator 3 and the cover 4 and dried to be a rubber elastic resin that forms the sealant 7.

For example, the sealant 7 may be made of a resin having an elastic modulus lower than the elastic modulus of a material for each of the cover 4 and the heat dissipator 3. In this structure, the sealant 7 can deform elastically based on deformation of the cover 4 and the heat dissipator 3 deforming by, for example, expanding or contracting in response to, for example, a temperature rise or a temperature drop caused by the light emitter 2 emitting and not emitting light. The elastic deformation of the sealant 7 may thus reduce stress generated by, for example, the cover 4, the heat dissipator 3, and the first cable 6 expanding or contracting in response to, for example, the temperature rise or the temperature drop occurring before or after the light emitter 2 emits light although, for example, the cover 4, the heat dissipator 3, and the first cable 6 may have different thermal expansion coefficients. The first clearance G1 between the cover 4 and the heat dissipator 3 is thus less likely to expand, and the first cable 6 is less likely to, for example, deteriorate. The second cable 8, in addition to the first cable 6, is also less likely to, for example, deteriorate.

In this example, the sealant 7 made of a resin with a lower elastic modulus may further reduce stress generated by, for example, expansion or contraction of the cover 4, the heat dissipator 3, and the first cable 6 when the sealant 7 deforms elastically.

For example, the multiple light-emitting elements 21 emit ultraviolet light, and the sealant 7 may be made of a resin that is resistant to ultraviolet light (or UV resistant). In this case, the sealant 7 made of a UV resistant resin may be less likely to deteriorate when the multiple light-emitting elements 21 emit ultraviolet light. This reduces the likelihood of more foreign matter adhering to the light emitter 2. Being UV resistant may be, for example, being less likely to lose elasticity under ultraviolet irradiation. Being UV resistant may be, for example, being less likely to have cracks associated with curing or embrittlement under ultraviolet irradiation. Being UV resistant may be a property of maintaining a property of the sealant 7 to seal the light emitter 2 (also referred to as a sealing property) for a period up to the lifespan of the light source module 1. The lifespan of the light source module 1 may be, for example, a predetermined time in which the amount of light emitted from the light source module 1 remains higher than or equal to a predetermined threshold determined based on an initial value. The predetermined threshold may be set to, for example, 0.7 for the initial value that set as 1, or to another value exceeding 0.7. The predetermined time may be, for example, 15000 hours or may be set to another time exceeding 15000 hours. The property of maintaining a sealing property may be, for example, a property of preventing particles and mist generated around the light source module 1 from entering the light emitter 2. The UV-resistant resin is, for example, a UV-resistant adhesive such as a silicone adhesive. For example, a silicone adhesive may be placed along the peripheral edge E1 of the first clearance G1 between the heat dissipator 3 and the cover 4 and dried to be a UV-resistant resin that forms the sealant 7.

The first cable 6 includes, for example, a coating 61. The coating 61 may be an outer peripheral portion of the first cable 6. The coating 61 may be made of, for example, polyvinyl chloride or polyethylene. For example, the multiple light-emitting elements 21 may emit ultraviolet light, and the sealant 7 is made of a resin that is more UV-resistant than the coating 61. In this case, the sealant 7 made of a resin that is more UV-resistant than the material of the coating 61 of the first cable 6 may be less likely to deteriorate when the multiple light-emitting elements 21 emit ultraviolet light. This reduces the likelihood of more foreign matter adhering to the light emitter 2.

### 1-1-7. Second Cable

As illustrated in FIG. 3, the second cable 8 is electrically connected to, for example, a sensor 8s located in the first area A1. The second cable 8 may transfer an electric signal to and from the sensor 8s. The sensor 8s is, for example, a temperature sensor for monitoring the temperature of the light emitter 2. The temperature of the light emitter 2 may be, for example, the temperature of the multiple light-emitting elements 21. The temperature sensor may be, for example, a thermistor. The temperature sensor may be fixed to, for example, the first surface 31b of the base 31 of the heat dissipator 3 thermally connected to the light emitter 2. The temperature sensor may be fixed to the first surface 31b of the base 31 by, for example, fastening including screwing.

The second cable 8 may be, for example, a linear component (first linear component) including one or more layers of insulating coatings covering multiple electric wires (insulated wires) each including a linear conductor covered with an insulating protective film. The second cable 8 is not limited to the first linear component. The second cable 8 may be, for example, a linear member (second linear member) including a linear conductor covered with one or more layers of insulating coatings. The second cable 8 may be multiple second linear components separate from one another. In other words, the second cable 8 may include multiple second linear components.

For example, the second cable 8 includes a third end and a fourth end in pairs in the longitudinal direction. In other words, the third end is, for example, one end in the longitudinal direction of the second cable 8, and the fourth end is the other end opposite to the third end in the longitudinal direction of the second cable 8. The second cable 8 may receive a connector (also referred to as a second connector) 8t attached to, for example, the third end of the second cable 8. The second connector 8t may be a plug connector or a socket connector. In an example of the first embodiment, the second cable 8 includes the third end including the ends of two second linear components each attached to a single second connector 8t as illustrated in FIGs. 1 to 3. The single second connector 8t is a plug connector.

The fourth end of the second cable 8 may be electrically connected to the sensor 8s. The fourth end may be electrically connected to the sensor 8s with, for example, connection using a member such as a crimp terminal or by bonding such as soldering. A portion of the second cable 8 adjacent to the fourth end and the sensor 8s are located on the first area A1 in the internal space Is1 in the receding portion 4c1 of the cover 4. A portion of the second cable 8 adjacent to the third end may be located in the outside Os1 of the receding portion 4c1. The portion of the second cable 8 adjacent to the third end may be exposed outside the light source module 1. The second cable 8 can thus transmit an electric signal between the outside of the light source module 1 and the sensor 8s.

The light source module 1 may include one second cable 8 or two or more second cables 8. For example, the number of second cables 8 may be any number corresponding to the number of sensors 8s in the first area A1. For example, the light source module 1 including a fifth predetermined number of sensors 8s in the first area A1 may include the fifth predetermined number of second cables 8. The fifth predetermined number is a natural number greater than or equal to 1. The fifth predetermined number may be, for example, 1, 2, or 3. In an example of the first embodiment, the light source module 1 includes one second cable 8 as illustrated in FIGs. 1 to 3.

For example, the multiple light-emitting elements 21 emit ultraviolet light, and the sealant 7 may be made of a resin that is more UV-resistant than a material of the coating of the second cable 8. The coating of the second cable 8 may be included in an outer peripheral portion of the second cable 8. The coating of the second cable 8 may be made of a resin that is the same as or similar to the material of the coating 61.

### 1-1-8. Screw

The cover 4 is fastened and fixed to the heat dissipator 3 with the screw 9. The screw 9 may have a higher thermal conductivity than the resin forming the sealant 7. In this case, the screw 9 thermally connects the cover 4 and the heat dissipator 3. This structure may increase heat dissipation from the heat dissipator 3 through the screw 9 and the cover 4. The multiple light-emitting elements 21 may thus have a smaller temperature rise. The multiple light-emitting elements 21 may thus emit a stable amount of light. The screw 9 may be made of, for example, an iron-based material, stainless steel, brass, aluminum, or copper.

The screw 9 includes, for example, a head and a shank projecting from the head. The head may be, for example, disk-shaped and may include a hexagonal hole, a Phillips hole (also referred to as a cross-slotted hole), or a slotted hole in a portion opposite to the shank. The shank may be, for example, cylindrical and may include an external thread on its outer peripheral portion. The screw 9 is placed through the through-hole 4c2 in the cover 4 from a position adjacent to the fourth surface 4b. In this example, the head of the screw 9 is received in the larger-diameter portion of the through-hole 4c2 and is in contact with the receiving surface. The shank of the screw 9 extends through the smaller-diameter portion of the through-hole 4c2 and is also fitted into a screw hole open in the first surface 31b of the base 31. In this case, the cover 4 held between the head of the screw 9 and the base 31 is thus fastened to the heat dissipator 3 with the screw 9.

The light source module 1 may include one screw 9 or two or more screws 9. In this example, the cover 4 is more stably fixed to the heat dissipator 3 with one or more screws 9, and more heat is likely to dissipate from the heat dissipator 3 through, for example, the screws 9. For example, the number of screws 9 may be the same as the number of through-holes 4c2. In an example of the first embodiment, the light source module 1 includes four screws 9 as illustrated in FIG. 3.

### 1-2. Example of Manufacture of Light Source Module

An example of the light source module 1 according to the first embodiment described above may be manufactured as described below.

For example, as illustrated in FIG. 12, the light emitter 2 is fixed to the base 31 of the heat dissipator 3 at a position adjacent to the first surface 31b, and the first cable 6 is electrically connected to the light emitter 2. The light emitter 2 may be fixed to the base 31 first, or the first cable 6 may be connected to the light emitter 2 first. For example, the substrate 22 in the light emitter 2 may be fixed to the base 31 of the heat dissipator 3 at a position adjacent to the first surface 31b by, for example, screwing. For example, thermal grease may be between the first surface 31b of the base 31 and the substrate 22. In this example, the sensor 8s may be, for example, screwed and fixed to the base 31 of the heat dissipator 3 at a position adjacent to the first surface 31b. The first cable 6 may be electrically connected to the wiring conductor on the substrate 22 in the light emitter 2 with, for example, connection using a member such as a crimp terminal or by bonding such as soldering. The second cable 8 may be electrically connected to the sensor 8s with, for example, connection using a member such as a crimp terminal or by bonding such as soldering.

As illustrated in FIGs. 13 to 16, for example, the light-emission opening 4o in the cover 4 is then covered by the light-transmissive member 5, and the heat dissipator 3 and the cover 4 are aligned. The light-emission opening 4o may be covered by the light-transmissive member 5 first, or the heat dissipator 3 and the cover 4 may be aligned first. For example, the light-transmissive member 5 may be slid along the light-emission opening 4o in the cover 4 in the positive X-direction or in the negative X-direction, and the holders F1 may hold the light-transmissive member 5. For example, the heat dissipator 3 may be placed on the cover 4 with the two projections C1 on the base 31 of the heat dissipator 3 being placed into the two recesses D1 in the receding portion 4c1 of the cover 4, and the heat dissipator 3 may be aligned with the cover 4. In this case, the first clearance G1 extends between the base 31 of the heat dissipator 3 and the cover 4, and the second opening O2 receiving the first cable 6 extends between the receding portion 4c1 of the cover 4 and the base 31 of the heat dissipator 3. The second opening O2 may receive, for example, the second cable 8.

For example, the cover 4 is then attached to the heat dissipator 3 as illustrated in FIG. 17. In other words, for example, the cover 4 is fixed to the heat dissipator 3. For example, the cover 4 may be fixed to the heat dissipator 3 with the screw 9.

For example, as illustrated in FIGs. 1, 2, 4, and 5, the sealant 7 covers the first clearance G1 between the heat dissipator 3 and the cover 4 along the peripheral edge E1 of the first clearance G1. The sealant 7 also covers the second opening O2 through which the first cable 6 extends. In this example, the sealant 7 may cover the second opening O2 through which the first cable 6 and the second cable 8 extend.

In this manner, an example of the light source module 1 according to the first embodiment may be manufactured.

### 1-3. Light Irradiator

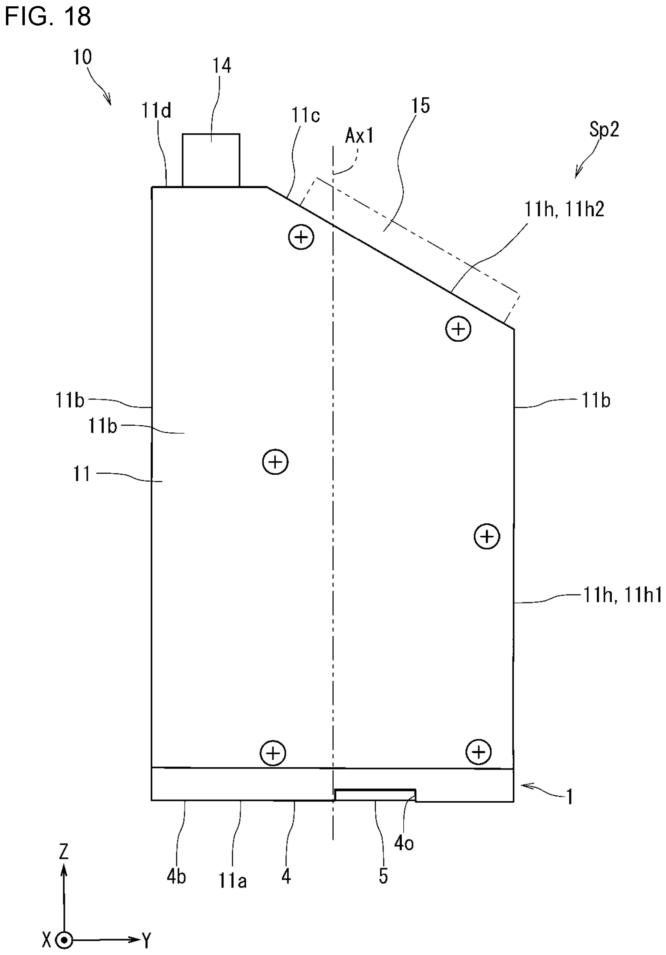

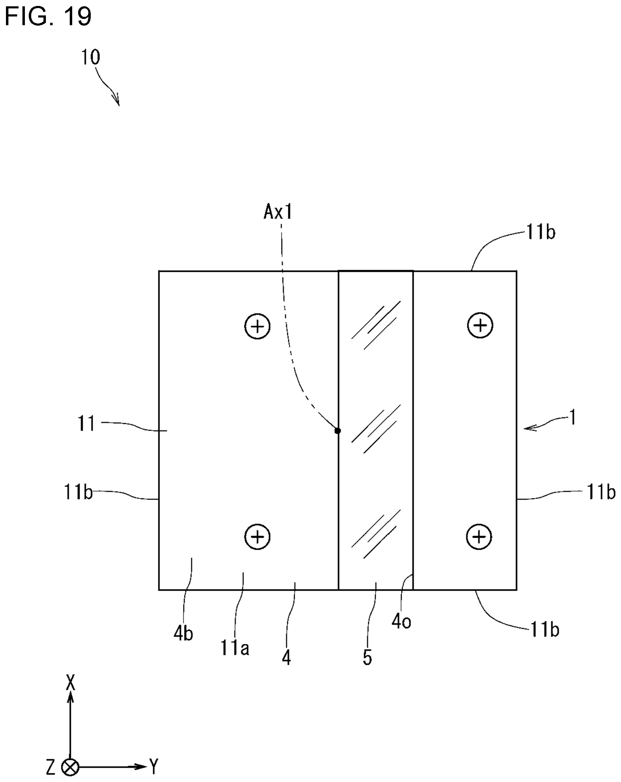

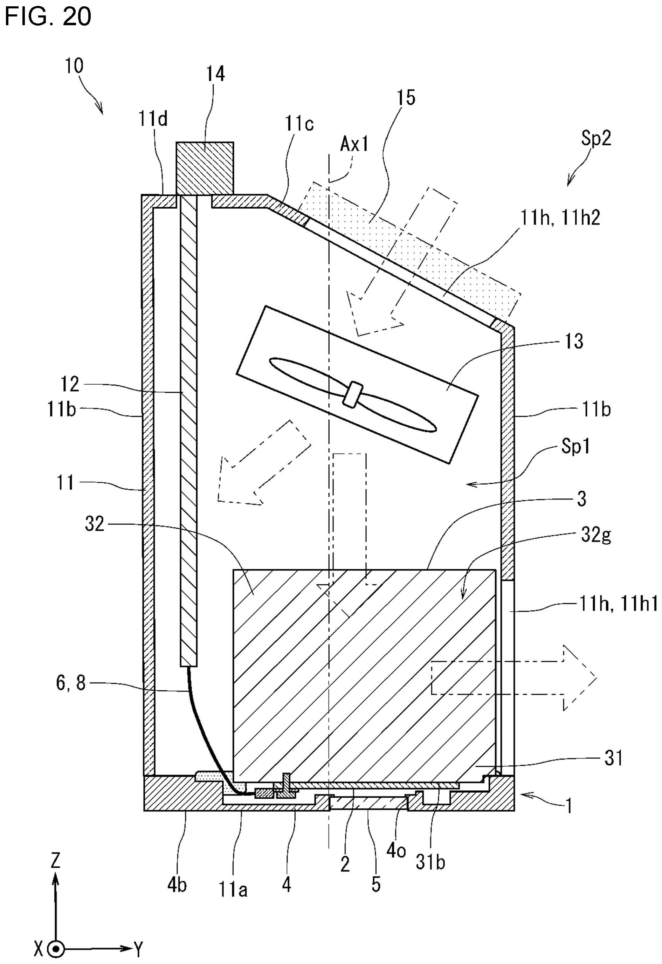

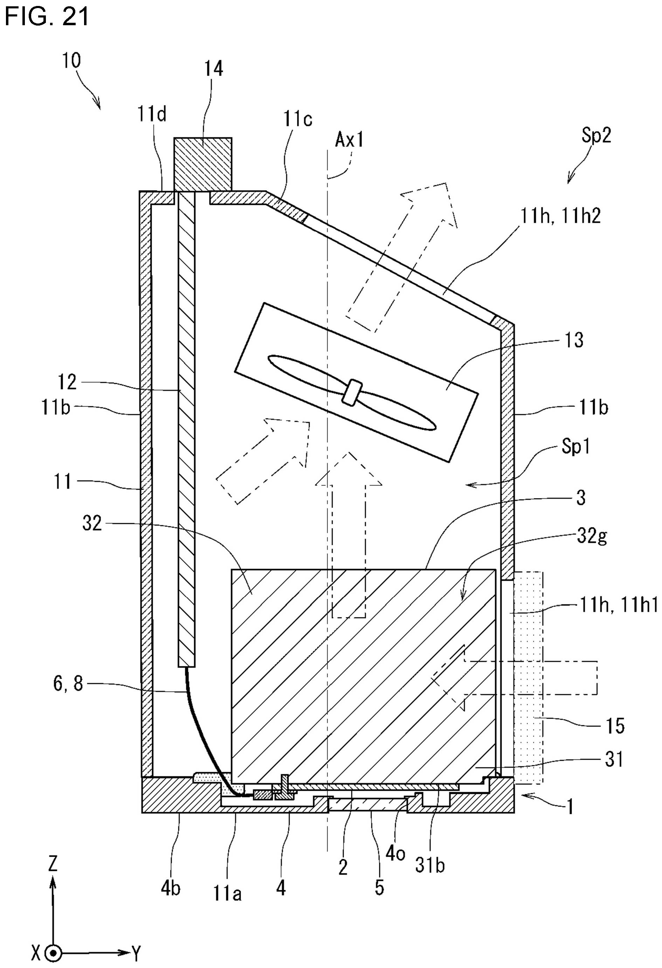

FIG. 18 is a side view of the light irradiator 10 according to the first embodiment, illustrating an example appearance. FIG. 19 is a bottom view of the light irradiator 10 according to the first embodiment, illustrating an example appearance. FIG. 20 is a schematic cross-sectional view of the light irradiator 10 according to the first embodiment, illustrating an example structure. FIG. 21 is a schematic cross-sectional view of the light irradiator 10 according to the first embodiment, illustrating another example structure. In FIGs. 18 to 21, the first cable 6 and the second cable 8 are schematically illustrated with a single thick line. In this example, the positive Z-direction in FIGs. 18 to 21 is also referred to as an upward direction for convenience. The negative Z-direction in FIGs. 18 to 21 is also referred to as a downward direction for convenience. The positive Y-direction in FIGs. 18 to 21 is also referred to as a right direction for convenience. The negative Y-direction in FIGs. 18 to 21 is also referred to as a left direction for convenience. The negative X-direction in FIGs. 18 to 21 is also referred to as a depth direction for convenience. The positive X-direction in FIGs. 18 to 21 is also referred to as a forward direction for convenience.

The light irradiator 10 irradiates an irradiation target with light.

As illustrated in FIGs. 18 to 21, the light irradiator 10 includes the light source module 1, a housing 11, and a drive 12. In an example of the first embodiment, the light irradiator 10 includes a blower 13 and a connector (also referred to as a third connector) 14.

The housing 11 surrounds, together with the cover 4, the light emitter 2 and the heat dissipator 3. The housing 11 and the cover 4 may define, for example, a profile of the light irradiator 10. The housing 11 may be, for example, directly fixed to the cover 4 or may be fixed to the heat dissipator 3 and thus indirectly to the cover 4. The housing 11 includes an internal space (also referred to as a first space) Sp1 surrounded by the housing 11. In other words, the first space Sp1 may be a hollow space surrounded by the housing 11 and the cover 4. In an example of the first embodiment, the light irradiator 10 includes the light emitter 2, the heat dissipator 3, the first cable 6, the second cable 8, the drive 12, and the blower 13 in the first space Sp1 in the housing 11. The housing 11 may be made of, for example, a metal such as aluminum or another material such as plastic in the same manner as or in a similar manner to the cover 4.

In an example of the first embodiment, the housing 11 and the cover 4 define a substantially rectangular prism profile for the light irradiator 10. The light irradiator 10 includes, for example, a lower surface 11a, side surfaces 11b, an inclined surface 11c, and an upper surface 11d.

The lower surface 11a may be a surface that allows light from the light emitter 2 to be emitted outside the light irradiator 10 through the light-transmissive member 5 covering the light-emission opening 4o. The lower surface 11a may include, for example, the fourth surface 4b of the cover 4 and a surface of the light-transmissive member 5 opposite to the light emitter 2. The lower surface 11a may face, for example, downward. Light from the light emitter 2 may be emitted, for example, downward from the lower surface 11a.

The side surfaces 11b may surround the first space Sp1 in, for example, directions along the lower surface 11a. In other words, the side surfaces 11b may surround the first space Sp1 at, for example, positions lateral to the first space Sp1. More specifically, the side surfaces 11b may extend, for example, in a vertical direction.

The inclined surface 11c and the upper surface 11d may extend in a portion of the light irradiator 10 opposite to the lower surface 11a. The inclined surface 11c and the upper surface 11d may extend in an area opposite to the lower surface 11a with the first space Sp1 between the area and the lower surface 11a. The inclined surface 11c and the upper surface 11d may extend in, for example, an upper portion of the light irradiator 10. In other words, the inclined surface 11c and the upper surface 11d may form, for example, an upper outer surface of the housing 11. The upper surface 11d may face in, for example, a direction opposite to the direction in which the lower surface 11a faces. In other words, the upper surface 11d may face, for example, upward. The upper surface 11d may be parallel to the lower surface 11a, slightly inclined with respect to the lower surface 11a, slightly curved, or slightly uneven. The inclined surface 11c connects, for example, the upper surface 11d and a side surface 11b, and may be inclined with respect to any of the lower surface 11a, the side surface 11b, or the upper surface 11d. The lower surface 11a, the side surface 11b, the inclined surface 11c, and the upper surface 11d may be connected in this order in, for example, a direction from the lower surface 11a to the upper surface 11d. The inclined surface 11c may face, for example, obliquely upward. In an example of the first embodiment, the inclined surface 11c extends in the upper portion of the housing 11 at a position in the rightward direction (positive Y-direction) as illustrated in FIGs. 18, 20, and 21. The upper surface 11d extends in the upper portion of the housing 11 at a position in the left direction (negative Y-direction).

The light irradiator 10 has a substantially rectangular prism profile with, for example, a height of about 150 mm as a length in the vertical direction, a width of about 100 mm as a length in a lateral direction, and a depth of about 80 mm as a length in the depth direction. The profile of the light irradiator 10 formed by the housing 11 and the cover 4 may be shaped variously based on the use of the light irradiator 10. The housing 11 and the cover 4 may define the profile of the light irradiator 10 in any shape such as a cube, a triangular prism, a cylinder, or a semicylinder. The profile of the light irradiator 10 may have any size other than the height, the width, and the depth described above. The profile of the light irradiator 10 may be shaped variously based on the use of the light irradiator 10.

For example, a printing apparatus is a line printer including, as a printing unit, an inkjet (IJ) head having substantially the same width as a print medium such as a paper sheet. When the light irradiator 10 is used in this printing apparatus, for example, multiple light irradiators 10 may be aligned in the positive X-direction as a width direction of the print medium to have a total width substantially the same as the width of the print medium. The light irradiator 10 may have a depth that is substantially the same length as the width of the print medium.

The housing 11 includes two or more vents 11h. The two or more vents 11h each connect the first space Sp1 inside the housing 11 and a space (also referred to as a second space) Sp2 outside the housing 11. The two or more vents 11h include a first vent 11h1 and a second vent 11h2. The first vent 11h1 may be open in, for example, the side surface 11b. More specifically, the first vent 11h1 may be, for example, adjacent to the multiple second clearances 32g between the multiple protrusions 32 in a direction along the first surface 31b of the base 31. More specifically, the first vent 11h1 may be, for example, adjacent to each of the multiple second clearances 32g in the direction along the first surface 31b of the base 31. The direction along the first surface 31b may be, for example, a direction parallel to the positive Y-direction. The second vent 11h2 may be at a position opposite to the cover 4 with respect to the heat dissipator 3. In other words, the heat dissipator 3 may be, for example, located between the second vent 11h2 and the cover 4. As illustrated in FIGs. 18, 20, and 21, the second vent 11h2 may be open in, for example, the inclined surface 11c. The housing 11 may thus be, for example, smaller with a larger size (opening area) of the second vent 11h2. Inflow or outflow of air through the second vent 11h2 is thus likely to increase between the first space Sp1 in the housing 11 and the second space Sp2 outside the housing 11. The light emitter 2 may thus be cooled more efficiently with the heat dissipator 3.

The first vent 11h1 and the second vent 11h2 may each be in, for example, an area shifted in a predetermined direction perpendicular to a first imaginary central axis (also referred to as a first imaginary central axis) Ax1 from an area extending about the imaginary central axis Ax1 extending through the center of the lower surface 11a and perpendicularly to the lower surface 11a. The first imaginary central axis Ax1 may be, for example, an imaginary central axis extending in the vertical direction of the housing 11. The center of the light-emission opening 4o may be, for example, shifted from the center point of the lower surface 11a in the predetermined direction. The heat dissipator 3 may be located in an area shifted in the predetermined direction from the area extending about the first imaginary central axis Ax1. In this structure, for example, more of the air flowing between the first vent 11h1 and the second vent 11h2 in the first space Sp1 is likely to flow through the second clearances 32g in the heat dissipator 3. The light emitter 2 may thus be efficiently cooled based on, for example, the arrangement of the light emitter 2 and the heat dissipator 3. The predetermined direction may be, for example, the positive Y-direction as the right direction.

In an example of the first embodiment, the first vent 11h1 is open in a portion of the side surface 11b in the right direction (positive Y-direction) as illustrated in FIGs. 18 to 21. The second vent 11h2 is open in the inclined surface 11c extending in an upper portion of the housing 11 at a position in the right direction (positive Y-direction). In the first space Sp1 inside the housing 11, the light emitter 2 and the heat dissipator 3 are located in an area shifted in the right direction (positive Y-direction) from an area extending about the first imaginary central axis Ax1.

The drive 12 includes a circuit (also referred to as a drive circuit) to drive the light emitter 2. The drive 12 is electrically connected to the light emitter 2. The drive 12 is electrically connected to the light emitter 2 with the first cable 6. In other words, the first cable 6 electrically connects the light emitter 2 and the drive 12. The drive 12 supplies power for light emission of the multiple light-emitting elements 21 in the light emitter 2. This allows, in the light irradiator 10, power supply from outside the light source module 1 to the light emitter 2 and may reduce foreign matter adhering to the light emitter 2. In this example, electrical connection from outside the light irradiator 10 to the drive 12 allows electrical connection from outside the light source module 1 to the light emitter 2. This allows, in the light irradiator 10, electrical connection from outside the light source module 1 to the light emitter 2 and may reduce foreign matter adhering to the light emitter 2. The drive 12 may be connected to, for example, the sensor 8s with the second cable 8. Although not illustrated in FIGs. 20 and 21, for example, the first connector 6t, or a plug connector, on the first cable 6 may be connected to a socket connector included in the drive 12, or the second connector 8t, or a plug connector, on the second cable 8 may be connected to a socket connector included in the drive 12.

The drive 12 may include, for example, a wiring board and the drive circuit. The wiring board may be, for example, a printed circuit board. The wiring board is fixed at, for example, a position adjacent to the inner surface of the housing 11. For example, the wiring board may be fixed at a position adjacent to the inner surface of the housing 11 by, for example, screwing with, for example, a stand, a supporting rod, or a spacer placed on the inner surface of the housing 11. For example, the wiring board fitted into an uneven portion on the inner surface of the housing 11 may be fixed at a position adjacent to the inner surface of the housing 11. The wiring board may be located, for example, along an imaginary plane parallel to an XZ plane.

The drive circuit includes, for example, one or more electronic components. The one or more electronic components are attached to, for example, the wiring board. The drive circuit may, for example, supply power to the light emitter 2 and control light emission of the light emitter 2. The drive circuit may also, for example, supply power to the blower 13 and control the operation of the blower 13. For example, the drive circuit may control the rotation speed of the blower 13 based on a heat generation state in the light emitter 2. The drive circuit may identify the heat generation state in the light emitter 2 with, for example, an electric signal from the sensor 8s through the second cable 8.

The drive 12 including the drive circuit generates heat while driving the light emitter 2. When the one or more electronic components include multiple electronic components, the drive circuit including multiple electronic components in an uncrowded manner may have a smaller temperature rise. When the one or more electronic components include, for example, an electronic component such as a power transistor that tends to generate more heat, the drive 12 may include a heat sink to increase heat dissipation from the electronic component. For an effective air flow onto parts of the drive 12 that easily reach high temperatures, the housing 11 may include at least one selected from, for example, grooves, fins, or an air deflector on a portion of the inner surface of the housing 11 around the drive 12.

The blower 13 is located between the heat dissipator 3 and the second vent 11h2. For example, the blower 13 may blow air to the heat dissipator 3 as illustrated in FIG. 20 or to the second vent 11h2 as illustrated in FIG. 21. In other words, the blower 13 may blow air to, for example, the heat dissipator 3 or the second vent 11h2. The blower 13 may thus generate, between the second vent 11h2 in the inclined surface 11c and the first vent 11h1 lateral to the heat dissipator 3, an airflow that can efficiently cool the heat dissipator 3. The blower 13 blowing air may thus improve the efficiency of cooling the heat dissipator 3. The light emitter 2 may thus be cooled efficiently with the heat dissipator 3.

In FIG. 20, an example airflow introduced from the second space Sp2 outside the housing 11 to the first space Sp1 in the housing 11 through the second vent 11h2 in the inclined surface 11c is schematically illustrated as an arrow drawn with thin two-dot-dash lines. An example airflow from the blower 13 to the heat dissipator 3 is schematically illustrated as an arrow drawn with thin two-dot-dash lines. An example airflow from an area along the heat dissipator 3 to the second space Sp2 outside the housing 11 through the first vent 11h1 in the side surface 11b is schematically illustrated as an arrow drawn with thin two-dot-dash lines. An example airflow from the blower 13 to the drive 12 is schematically illustrated as an arrow drawn with thin two-dot-dash lines. As illustrated in FIG. 20, the blower 13 blowing air to the heat dissipator 3 generates, for example, an airflow of air introduced through the second vent 11h2 in the inclined surface 11c from the second space Sp2 outside the housing 11 to the first space Sp1 inside the housing 11 to cause the air to travel through an area along the heat dissipator 3 and out of the first vent 11h1 in the side surface 11b into the second space Sp2 outside the housing 11.

In FIG. 21, an example airflow introduced from the second space Sp2 outside the housing 11 to the first space Sp1 in the housing 11 through the first vent 11h1 in the side surface 11b is schematically illustrated as an arrow drawn with thin two-dot-dash lines. An example airflow from an area along the heat dissipator 3 to the blower 13 is schematically illustrated as an arrow drawn with thin two-dot-dash lines. An example airflow from the blower 13 to the second space Sp2 outside the housing 11 through the second vent 11h2 in the inclined surface 11c is schematically illustrated as an arrow drawn with thin two-dot-dash lines. An example airflow from an area along the drive 12 to the blower 13 is schematically illustrated as an arrow drawn with thin two-dot-dash lines. As illustrated in FIG. 21, the blower 13 blowing air to the second vent 11h2 may generate, for example, an airflow of air introduced through the first vent 11h1 in the side surface 11b from the second space Sp2 outside the housing 11 to the first space Sp1 in the housing 11 to cause the air to travel through the area along the heat dissipator 3 and out of the second vent 11h2 in the inclined surface 11c into the second space Sp2 outside the housing 11.

When the blower 13 blows air in a direction close to a direction perpendicular to the second vent 11h2, for example, the blower 13 may efficiently blow air to a portion of the heat dissipator 3 farther from the second vent 11h2, and the airflow may have a smaller pressure drop in the second vent 11h2. The direction in which the blower 13 blows air may or may not be perpendicular to the second vent 11h2. The blower 13 may be spaced from either of the second vent 11h2 or the heat dissipator 3 or may be close to or in contact with either of the second vent 11h2 or the heat dissipator 3.

The blower 13 that is, for example, an axial fan is smaller and, at the same time, can generate more airflow. The blower 13 may be, for example, another type of fan other than an axial fan. The blower 13 is fixed at, for example, a position adjacent to the inner surface of the housing 11. For example, the blower 13 may be fixed at a position adjacent to the inner surface of the housing 11 by, for example, screwing with a stand, a support rod, or a spacer placed on the inner surface of the housing 11.

For example, a smaller housing 11 may include a larger drive 12 when the heat dissipator 3 and the blower 13 are located between the inclined surface 11c and the lower surface 11a and the drive 12 is located between the upper surface 11d and the lower surface 11a. For example, the drive 12 may extend along the side wall of the housing 11 as illustrated in FIGs. 20 and 21. When the drive 12 generates heat, the heat may be efficiently dissipated from the drive 12 to the second space Sp2 outside the housing 11 through the side wall of the housing 11. The drive 12 may thus be cooled efficiently with the housing 11. For example, the drive 12 located closer to the second vent 11h2 than to the heat dissipator 3 may increase an airflow in an area in contact with the drive 12 in the first space Sp1 in the housing 11. The drive 12 may thus be cooled efficiently.

For example, the first vent 11h1 in the side surface 11b connecting a portion of the inclined surface 11c adjacent to the lower surface 11a and the lower surface 11a may increase an airflow in the first space Sp1 in the housing 11 at a position adjacent to the side surface 11b including the first vent 11h1. In this structure, the housing 11 may include a larger side surface 11b at a position opposite to the side surface 11b including the first vent 11h1. For example, the light irradiator 10 to be mounted on various apparatuses such as a printing apparatus may thus be easily attached to and aligned with various structures at a position adjacent to the side surface 11b of the housing 11 opposite to the side surface 11b including the first vent 11h1.

The third connector 14 connects multiple wires connected to the drive 12 and multiple wires outside the housing 11. The third connector 14 may extend, for example, along the outer surface of the housing 11 or through the housing 11. The light irradiator 10 may include one third connector 14 or two or more third connectors 14. In an example of the first embodiment, the third connector 14 is located adjacent to the upper surface 11d of the housing 11 as illustrated in FIGs. 18, 20, and 21. The multiple wires include, for example, wires (also referred to as power lines) for supplying power from an external source to the drive 12 and wires (also referred to as signal lines) for receiving signals from an external device to the drive 12 and transmitting signals from the drive 12 to the external device. The drive 12 can, for example, receive power from the source external to the light irradiator 10 and transmit or receive control signals to or from the device external to the light irradiator 10 through the third connector 14.

For example, the light irradiator 10 may include a filter 15 attached to the first vent 11h1 or the second vent 11h2 as illustrated in, for example, FIGs. 18, 20, and 21. In FIGs. 18 and 20, the filter 15 attached to the second vent 11h2 includes an outer edge drawn with a thin two-dot-dash line. In FIG. 21, the filter 15 attached to the first vent 11h1 includes an outer edge drawn with a thin two-dot-dash line. The light irradiator 10 may include, for example, the filter 15 attached to each of the first vent 11h1 and the second vent 11h2. The filter 15 including, for example, sponge or non-woven fabric may reduce foreign matter, such as dust and dirt, entering the first space Sp1 in the housing 11 from the second space Sp2 outside the housing 11. For example, dust and dirt are thus less likely to accumulate on the heat dissipator 3 and the drive 12, and the efficiency of heat dissipation from the light emitter 2 and the drive 12 is less likely to be lower. This may improve, for example, the reliability of the light irradiator 10. The filter 15 may also decelerate the airflow around the vent 11h receiving the filter 15. For example, the filter 15 absorbing operating sound from the blower 13 included in the housing 11 can also reduce noise generated by the blower 13 in the light irradiator 10.

In FIGs. 18 and 19, a mark of circled plus indicates the screw. The number of screws and the positions of the screws may be determined as appropriate based on the design of the light source module 1 and the housing 11.

### 1-4. Printing Apparatus

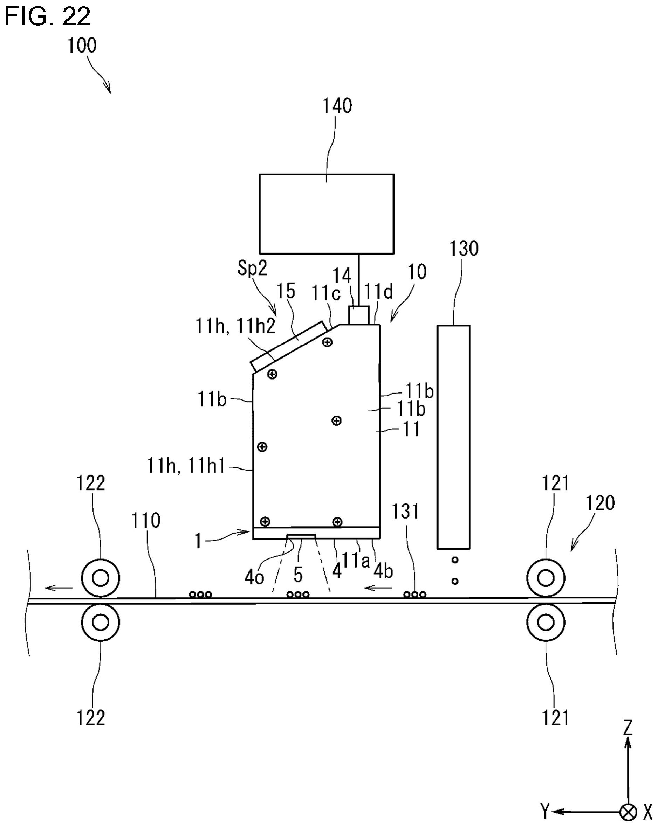

FIG. 22 is a schematic diagram of an example of a printing apparatus 100 in the first embodiment.

As illustrated in FIG. 22, the printing apparatus 100 includes the light irradiator 10 described above, a feeder 120, a printing unit 130, and a controller 140.

The feeder 120 can feed a print medium 110 in a predetermined direction (also referred to as a feed direction). The print medium 110 is an object to be printed by the printing apparatus 100. The print medium 110 may be, for example, a paper sheet or a resin sheet, or a thin plate made of a resin, a semiconductor, a metal, or wood. In the example in FIG. 22, the feeder 120 can feed the print medium 110 placed along an imaginary plane parallel to a horizontal surface in the positive Y-direction as the feed direction. The width direction of the print medium 110 is the positive X-direction as a direction perpendicular to the feed direction of the print medium 110. The thickness direction of the print medium 110 is the positive Z-direction. In FIG. 22, the feed direction is indicated by the arrows drawn with thin solid lines.

In the example in FIG. 22, the printing unit 130 and the light irradiator 10 are aligned in this order in the positive Y-direction as the feed direction above the print medium 110 being fed by the feeder 120.

As illustrated in FIG. 22, the feeder 120 may include, for example, a pair of feed rollers (also referred to as first feed rollers) 121 upstream from the printing apparatus 100 and a pair of feed rollers (also referred to as second feed rollers) 122 downstream from the printing apparatus 100. The pair of first feed rollers 121 and the pair of second feed rollers 122 each sandwich the print medium 110 from above and below to hold the print medium 110. The print medium 110 can be fed in the feed direction as the pair of downstream second feed rollers 122 and the pair of upstream first feed rollers 121 rotate. The rotation of each of the pair of first feed rollers 121 may be driven by, for example, an electric motor. The rotation of each of the pair of second feed rollers 122 may be driven by, for example, an electric motor. The feeder 120 may include, for example, a support that supports the print medium 110 from below between the pair of upstream first feed rollers 121 and the pair of downstream second feed rollers 122. The support may include, for example, multiple tubular or cylindrical rollers (also referred to as support rollers). The multiple support rollers may each have an axial direction perpendicular to the feed direction and may be arranged in the feed direction.

The printing unit 130 can print on the print medium 110. The printing unit 130 is located at a position in a direction opposite to the feed direction (or upstream) from the light irradiator 10. In other words, the printing unit 130 is located upstream from the light irradiator 10 in the feed direction of the print medium 110. The printing unit 130 is, for example, an IJ head that ejects ink 131. The IJ head may be, for example, a line IJ head including multiple nozzles arranged linearly. The multiple nozzles may be arranged in a direction substantially perpendicular to the feed direction. The multiple nozzles each include an orifice for ejecting ink 131. The ink 131 is photocurable ink as a photosensitive material. Photocurable ink is cured (or photocured) in response to irradiation with light in a specific wavelength range. Photocurable ink is, for example, ultraviolet curable ink (also referred to as UV ink) that is cured (photocured) in response to irradiation with ultraviolet light in a specific wavelength range. The printing unit 130 ejects, for example, the ink 131 onto an upper surface of the print medium 110 being fed by the feeder 120 to apply the ink 131 on the upper surface of the print medium 110. The IJ head as the printing unit 130 ejects, for example, droplets of the ink 131 onto the upper surface of the print medium 110 being fed by the feeder 120 to apply the droplets of the ink 131 on the upper surface of the print medium 110. For example, the printing unit 130 can apply the ink 131 to the upper surface of the print medium 110 in an intended pattern. The printing unit 130 may apply the ink 131 to, for example, substantially the entire upper surface of the print medium 110 or a part of the upper surface of the print medium 110.

The light irradiator 10 can irradiate the print medium 110 being fed by the feeder 120 in the feed direction with light through the light-emission opening 4o. The light irradiator 10 is located downstream from the printing unit 130 in the feed direction in which the print medium 110 is fed by the feeder 120. The lower surface 11a of the light irradiator 10 faces downward. The light irradiator 10 can thus irradiate the ink 131 applied on the upper surface of the print medium 110 with light through the light-emission opening 4o. In FIG. 22, the outer edge of a light path of light applied to the print medium 110 through the light-emission opening 4o is schematically illustrated with thin two-dot-dash lines.

When the ink 131 is photocurable ink, the ink 131 applied on the upper surface of the print medium 110 may be cured with light from the light irradiator 10 that irradiates the upper surface of the print medium 110 with light in a specific wavelength for curing (photocuring) photocurable ink. When, for example, the ink 131 is ultraviolet curable ink (UV ink), the UV ink as the ink 131 applied on the upper surface of the print medium 110 may be cured with the light irradiator 10 that irradiates the upper surface of the print medium 110 with ultraviolet light as light in a specific wavelength range.

For example, the light irradiator 10 may include the light-emission opening 4o near a portion of the light irradiator 10 farther from the printing unit 130 in the feed direction of the print medium 110. This may reduce the effect of light through the light-emission opening 4o in the light irradiator 10 on the printing unit 130. For example, less light may travel around toward the printing unit 130 through the light-emission opening 4o in the light irradiator 10. The IJ head in the printing unit 130 is thus less likely to have nozzle clogging when, for example, the ink 131 is UV ink.

For example, the inclined surface 11c of the light irradiator 10 may face downstream in the feed direction as illustrated in FIG. 22. In other words, for example, the first vent 11h1 and the second vent 11h2 in the light irradiator 10 may face downstream in the feed direction. In other words, the first vent 11h1 and the second vent 11h2 in the light irradiator 10 may face an area opposite to an area including the printing unit 130. In this structure, turbulence resulting from inflow or outflow of air through the first vent 11h1 and the second vent 11h2 in the light irradiator 10 may have a smaller effect on the printing unit 130. More specifically, this structure reduces, for example, changes in the trajectory of droplets of ink 131 ejected from the printing unit 130 to the print medium 110 caused by the turbulence resulting from inflow and outflow of air. This may reduce the ink 131 applied on the upper surface of the print medium 110 with a lower positional accuracy.

For example, the inclined surface 11c of the light irradiator 10 may face upstream in the feed direction. In other words, for example, the first vent 11h1 and the second vent 11h2 in the light irradiator 10 may face upstream in the feed direction. In other words, the first vent 11h1 and the second vent 11h2 in the light irradiator 10 may face an area including the printing unit 130. In this structure, the light-emission opening 4o may be closer to the printing unit 130 in the feed direction of the print medium 110. This may shorten the time from the time at which the ink 131 is applied on the upper surface of the print medium 110 to the time at which the ink 131 applied on the upper surface of the print medium 110 is irradiated with light through the light-emission opening 4o. The ink 131 applied on the upper surface of the print medium 110 may thus be cured in a shorter time. This may reduce spread of the ink 131 on the upper surface of the print medium 110.

For example, the light irradiator 10 may include the light-emission opening 4o near a portion of the light irradiator 10 adjacent to the printing unit 130 in the feed direction of the print medium 110. This structure may allow the light-emission opening 4o in the light irradiator 10 father from the printing unit 130 to be closer to the printing unit 130 in the feed direction of the print medium 110. This may shorten the time from the time at which the ink 131 is applied on the upper surface of the print medium 110 to the time at which the ink 131 applied on the upper surface of the print medium 110 is irradiated with light through the light-emission opening 4o. This may reduce variations in leveling of the ink 131 on the upper surface of the print medium 110. The printing apparatus 100 is thus less likely to have a lower printing quality.

For example, the printing apparatus 100 may be a line printer including, as the printing unit 130, an IJ head having substantially the same width as the print medium 110. In this case, multiple light irradiators 10 may be aligned in the positive X-direction as the width direction of the print medium 110, and the total width of the light irradiators 10 may be substantially the same as the width of the print medium 110. The light irradiator 10 may have a depth that is substantially the same length as the width of the print medium 110. In this case, the light irradiator 10 may have a depth direction as a longitudinal direction. When the blower 13 is an axial fan, for example, the light irradiator 10 may include, in the first space Sp1, multiple blowers 13 aligned in the depth direction above one heat dissipator 3.

The controller 140 can control the operations of the components of the printing apparatus 100. The controller 140 includes, for example, various electric circuits such as a processor and a memory. The controller 140 is electrically connected to, for example, the components of the printing apparatus 100 with a cable or another member. For example, the controller 140 may be electrically connected to the third connector 14 in the light irradiator 10 with a cable or another member. The controller 140 can control, for example, feeding of the print medium 110 performed by the feeder 120. The controller 140 can control, for example, ejection of the ink 131 performed by the IJ head as the printing unit 130. The controller 140 can control, for example, light emission of the light irradiator 10.

When, for example, the ink 131 is photocurable ink, the memory in the controller 140 may store information indicating the properties of light relatively suitable for photocuring the ink 131 ejected from the IJ head as the printing unit 130. Examples of the information include numerical values representing the wavelength distribution characteristics and the intensity (the emission intensity for each wavelength range) of light suitable for photocuring droplets of the ink 131 ejected from the IJ head. In the printing apparatus 100, for example, the controller 140 may adjust the level of a drive current to be input into the multiple light-emitting elements 21 in the light emitter 2 in the light irradiator 10 based on the information in the memory. The light irradiator 10 thus emits, for example, an appropriate amount of light based on the characteristics of the ink used. This allows the ink 131 to be cured with relatively low-energy light.

### 1-5. Overview of First Embodiment

In the light source module 1 according to the first embodiment, the light emitter 2 is located between the first surface 31b of the base 31 of the heat dissipator 3 and the light-transmissive member 5 covering the light-emission opening 4o open in the receding portion 4c1 of the cover 4. The internal space Is1 in the receding portion 4c1 of the cover 4 receives the receivable portion 31p that is a part of the base 31 of the heat dissipator 3. The light source module 1 further includes, between the receding portion 4c1 and the base 31, the second opening O2 connecting to the first area A1 extending between the cover 4 and the first surface 31b of the base 31. The first cable 6 electrically connected to the light emitter 2 extends through the second opening O2. The sealant 7 covers the first clearance G1 between the heat dissipator 3 and the cover 4 along the peripheral edge E1 of the first clearance G1. The first cable 6 extends through the sealant 7 that covers the second opening O2. The sealant 7 is made of a resin. In this structure, the first cable 6 allows electrical connection from outside the light source module 1 to the light emitter 2. The sealant 7 covering the first clearance G1 along the peripheral edge E1 and the second opening O2 reduces foreign matter entering the light emitter 2 from outside the light source module 1. This allows electrical connection from outside the light source module 1 to the light emitter 2 and may reduce foreign matter adhering to the light emitter 2.

### 2. Other Embodiments

The present disclosure is not limited to the first embodiment described above and may be changed or varied in various manners without departing from the spirit and scope of the present disclosure.

### 2-1. Second Embodiment

In the first embodiment described above, for example, the cover 4 may not be fastened and fixed to the heat dissipator 3 with the screw 9. In this case, the light source module 1 may include no screw 9.

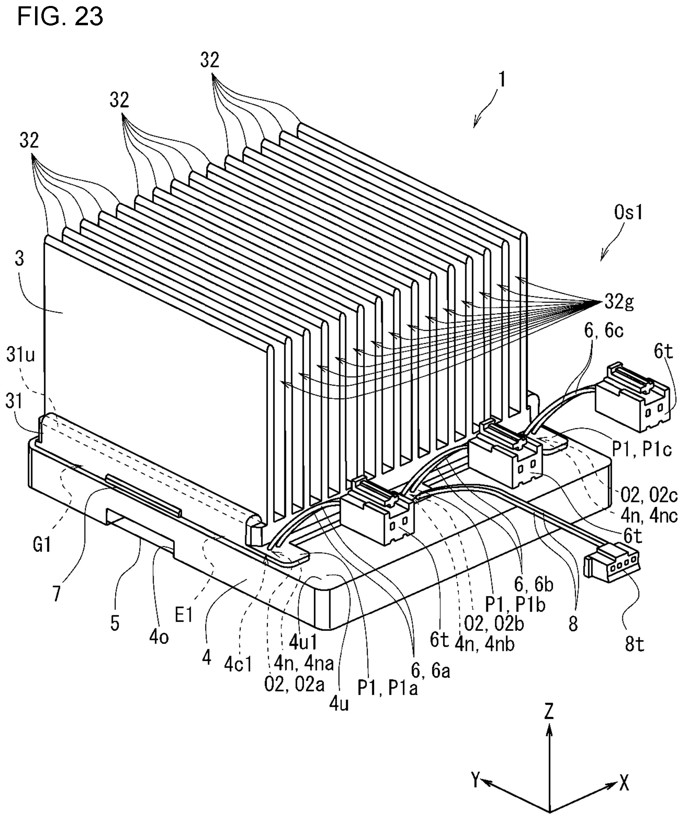

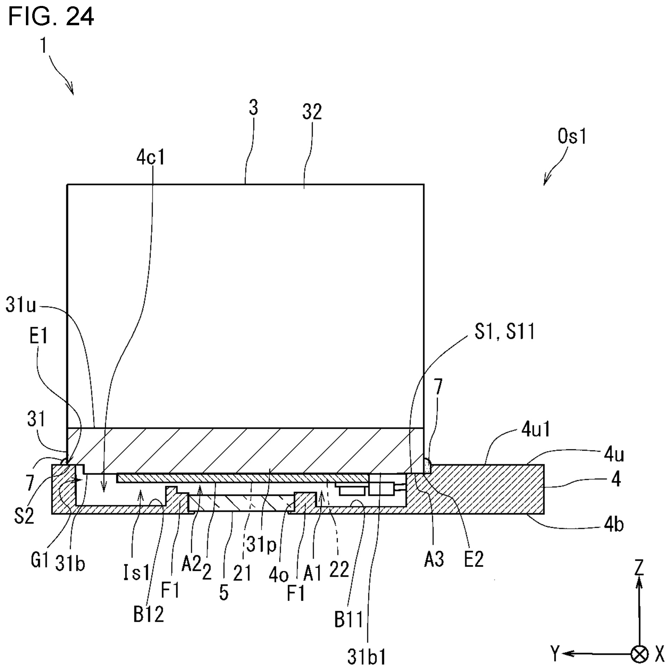

FIG. 23 is a perspective view of a light source module 1 according to a second embodiment, illustrating an example appearance. FIG. 24 is a schematic cross-sectional view of the light source module 1 according to the second embodiment, illustrating an example cross section. FIG. 24 schematically illustrates an example of an imaginary cross section of the light source module 1 according to the second embodiment at a position corresponding to the imaginary cross section in FIG. 5.

As illustrated in FIGs. 23 and 24, the cover 4 may be attached to the heat dissipator 3 with, for example, the sealant 7 in place of the screw 9. In this example, the sealant 7 may extend from the first clearance G1 to the second surface 31u of the heat dissipator 3 as illustrated in FIG. 23. For example, the sealant 7 may cover a portion of the heat dissipator 3 connecting the base 31 and the protrusions 32. In this structure, the cover 4 may be more strongly fixed to the heat dissipator 3 with the sealant 7. This reduces separation between the heat dissipator 3 and the cover 4. In an example of the second embodiment, the multiple protrusions 32 include two protrusions 32 at two ends, and the sealant 7 covers a portion of each of the two protrusions 32 connected to the base 31 as illustrated in FIG. 23. Heat dissipation from the heat dissipator 3 is less likely to decrease when, for example, the multiple second clearances 32g between the multiple protrusions 32 receive no sealant 7.

In this example, the light source module 1 may be produced with a simpler process when the cover 4 is attached to the heat dissipator 3 with the sealant 7 and without the screw 9. The sealant 7 deforms elastically based on deformation of the cover 4 and the heat dissipator 3 deforming by, for example, expanding or contracting in response to, for example, a temperature rise or a temperature drop caused by, for example, the light emitter 2 emitting and not emitting light. This may reduce stress generated between the heat dissipator 3 and the cover 4.

The cover 4, the heat dissipator 3, and the screw 9 may, for example, expand or contract in response to, for example, a temperature rise or a temperature drop caused by, for example, the light emitter 2 emitting and not emitting light. In this case, the cover 4 attached to the heat dissipator 3 with the sealant 7 and without the screw 9 is less likely to have a loosening screw 9 when a relatively weaker member of the cover 4, the heat dissipator 3, and the screw 9 deforms plastically. This may reduce, for example, intermittent vibrations (also referred to as chatter) between the cover 4 and the heat dissipator 3, and may improve the stability of the cover 4 attached to the heat dissipator 3. The light source module 1 may thus have practical strength and durability.

In an example of the second embodiment compared with an example of the first embodiment, the stepped portion S1 may be smaller or be partially eliminated as illustrated in FIG. 24. More specifically, for example, the first stepped portion S11 may be smaller, or the second stepped portion S12 may be eliminated.

### 2-2. Third Embodiment

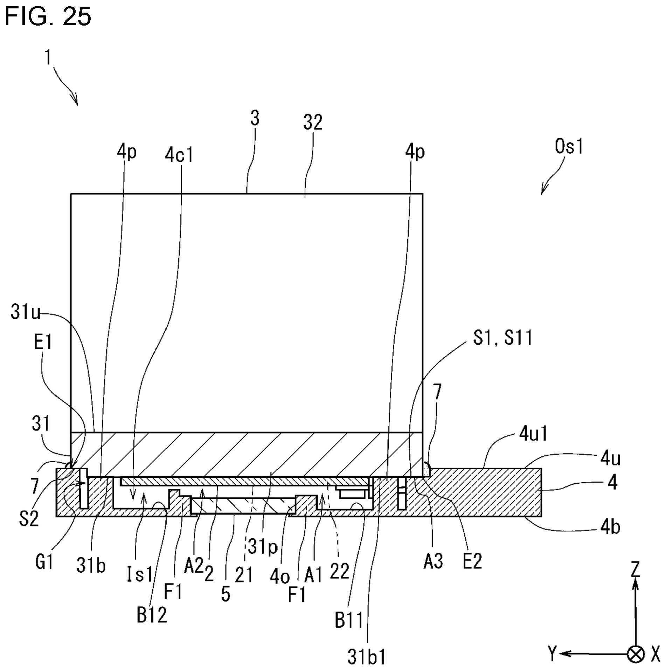

In the second embodiment, for example, the receding portion 4c1 may include one or more projecting portions 4p as illustrated in FIG. 25. The one or more projecting portions 4p may each be spaced from the one or more first stepped portions S11 and project toward the first surface 31b of the base 31. The one or more projecting portions 4p may each be in contact with the first surface 31b of the base 31. This structure increases the area of contact between the cover 4 and the heat dissipator 3, and may thus improve heat dissipation from the heat dissipator 3. The multiple light-emitting elements 21 may thus have a smaller temperature rise. The multiple light-emitting elements 21 are thus less likely to emit a smaller amount of light.

FIG. 25 is a schematic cross-sectional view of a light source module 1 according to a third embodiment, illustrating an example cross section. FIG. 25 schematically illustrates an example of an imaginary cross section of the light source module 1 according to the third embodiment at a position corresponding to the imaginary cross section in FIG. 5.

In this example, the number of one or more projecting portions 4p may be, for example, one, two, three, or any number greater than or equal to four. In FIG. 25, two projecting portions 4p are illustrated for convenience. The one or more projecting portions 4p may each be in contact with, for example, an area spaced from the outer peripheral area A3 in the first surface 31b of the base 31. The one or more projecting portions 4p may each be, for example, a cylindrical or prism-shaped pillar. The area of contact between the cover 4 and the heat dissipator 3 may be larger when, for example, a flat portion of the first surface 31b is in contact with the one or more projecting portions 4p and a flat portion of the one or more projecting portions 4p is in contact with the first surface 31b. In other words, the area of contact between the cover 4 and the heat dissipator 3 may be larger when, for example, the one or more projecting portions 4p are each in surface contact with the first surface 31b.

In this example, the structure according to the second embodiment described above and the structure according to the third embodiment described above may produce effects in a compatible manner.

For example, the first surface 31b of the base 31 may include, for example, a projecting portion that projects in a direction away from the second surface 31u and is in contact with the projecting portion 4p. The projecting portion may be, for example, a cylindrical or prism-shaped pillar.

### 2-3. Fourth Embodiment

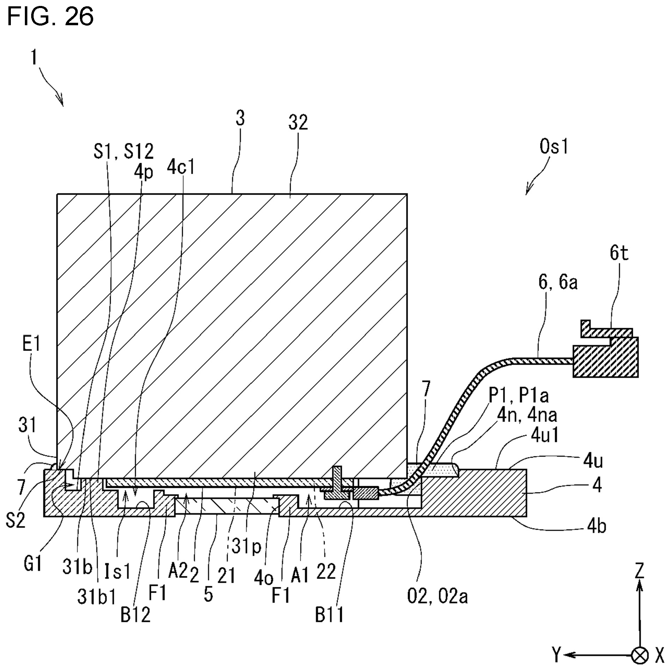

In the first embodiment described above, for example, the receding portion 4c1 may include the one or more projecting portions 4p as illustrated in FIG. 26. The one or more projecting portions 4p may each be spaced from the one or more first stepped portions S11 and project toward the first surface 31b of the base 31. The One or more projecting portions 4p may each be in contact with the first surface 31b of the base 31. This structure increases the area of contact between the cover 4 and the heat dissipator 3, and may thus improve heat dissipation from the heat dissipator 3. The multiple light-emitting elements 21 may thus have a smaller temperature rise. The multiple light-emitting elements 21 are thus less likely to emit a smaller amount of light.

FIG. 26 is a schematic cross-sectional view of a light source module 1 according to a fourth embodiment, illustrating an example cross section. FIG. 26 schematically illustrates an example of an imaginary cross section of the light source module 1 according to the fourth embodiment at a position corresponding to the imaginary cross section in FIG. 4.

In this example, the number of one or more projecting portions 4p may be, for example, one, two, three, or any number greater than or equal to four. In FIG. 26, one projecting portion 4p is illustrated for convenience. The one or more projecting portions 4p may each be in contact with, for example, an area spaced from the outer peripheral area A3 in the first surface 31b of the base 31. The one or more projecting portions 4p may each be, for example, a cylindrical or prism-shaped pillar. The area of contact between the cover 4 and the heat dissipator 3 may be larger when, for example, a flat portion of the first surface 31b is in contact with the one or more projecting portions 4p and a flat portion of the one or more projecting portions 4p is in contact with the first surface 31b. In other words, the area of contact between the cover 4 and the heat dissipator 3 may be larger when, for example, the one or more projecting portions 4p are each in surface contact with the first surface 31b.

For example, the first surface 31b of the base 31 may include, for example, a projecting portion that projects in a direction away from the second surface 31u and is in contact with the projecting portion 4p. The projecting portion may be, for example, a cylindrical or prism-shaped pillar.

### 3. Others

In each of the first embodiment, the second embodiment, the third embodiment, and the fourth embodiment, for example, the one or more first stepped portions S11 are each located in a portion of the outer peripheral portion of the receding portion 4c1 at an end in the negative Y-direction. However, the structure is not limited to this example. For example, the one or more first stepped portions S11 may each be located at an end of the outer peripheral portion of the receding portion 4c1 in the positive Y-direction, or may be located along the entire periphery of the outer peripheral portion of the receding portion 4c1. In other words, the receding portion 4c1 may include the one or more first stepped portions S11 each located in at least a part of the outer peripheral portion of the receding portion 4c1.

In each of the first embodiment, the second embodiment, the third embodiment, and the fourth embodiment, for example, the second cable 8 and the sensor 8s may be eliminated.

In each of the first embodiment, the second embodiment, the third embodiment, and the fourth embodiment, for example, an epoxy adhesive may be used as a resin forming the sealant 7. In this case, for example, an epoxy adhesive may be placed along the peripheral edge E1 of the first clearance G1 between the heat dissipator 3 and the cover 4 and dried to be the resin forming the sealant 7.

In each of the first embodiment, the second embodiment, the third embodiment, and the fourth embodiment, for example, the cover 4 includes one light-emission opening 4o. However, the structure is not limited to this example. For example, the cover 4 may include two or more light-emission openings 4o aligned in a direction along the fourth surface 4b.

In each of the first embodiment, the second embodiment, the third embodiment, and the fourth embodiment, for example, the receding portion 4c1 including the first extension 4n defines the second opening O2 between the receding portion 4c1 and the base 31. However, the structure is not limited to this example. For example, the base 31 including a notch may define the second opening O2 between the receding portion 4c1 and the base 31. The second opening O2 may be defined by the first extension 4n of the receding portion 4c1 and the notch in the base 31.

In each of the first embodiment, the second embodiment, the third embodiment, and the fourth embodiment, for example, the entire portion of the base 31 of the heat dissipator 3 may be received in the internal space Is1 in the receding portion 4c1. In other words, at least a portion (receivable portion) 31p of the base 31 of the heat dissipator 3 may be received in the internal space Is1 in the receding portion 4c1.

In each of the first embodiment, the second embodiment, the third embodiment, and the fourth embodiment, for example, each of the multiple protrusions 32 of the heat dissipator 3 may not be a thin plate, and may be in any other shape such as a rod.

In each of the first embodiment, the second embodiment, the third embodiment, and the fourth embodiment, for example, the sensor 8s may be another temperature sensor such as a thermocouple, or another sensor such as an optical sensor.

In each of the first embodiment, the second embodiment, the third embodiment, and the fourth embodiment, for example, the light irradiator 10 may include no blower 13 or no filter 15.

In each of the first embodiment, the second embodiment, the third embodiment, and the fourth embodiment, for example, the light irradiator 10 may include a netlike member in one or more vents 11h of the two or more vents 11h. This structure reduces foreign matter entering the first space Sp1 in the housing 11 from the second space Sp2 outside the housing 11. Examples of the foreign matter may include dust, dirt, a metal component, and a tool.

In each of the first embodiment, the second embodiment, the third embodiment, and the fourth embodiment, for example, the light irradiator 10 may include the housing 11 including a plate partition between the blower 13 and the drive 12, and the multiple vents 11h including a vent (also referred to as a third vent) open in the upper surface 11d. In this structure, the partition causes air to flow around outside the partition between the second vent 11h2 and the third vent. This may allow, in an area adjacent to the light source module 1 in the first space Sp1 in the housing 11, more air to flow in a portion spaced from the first vent 11h1. Additionally, more air may flow in an area along the drive 12. For example, the heat dissipator 3 and the drive 12 may thus be cooled efficiently. The light emitter 2 and the drive 12 may thus be cooled efficiently.

In each of the first embodiment, the second embodiment, the third embodiment, and the fourth embodiment, for example, the first space Sp1 in the housing 11 and the second space Sp2 outside the housing 11 for the light irradiator 10 may be filled with, in place of air, a gas such as an inert gas including, for example, a nitrogen gas.

In each of the first embodiment, the second embodiment, the third embodiment, and the fourth embodiment, for example, the printing unit 130 may include an IJ head that ejects, in place of photocurable ink, water- or oil-based ink as the ink 131. In this case, for example, the light irradiator 10 may irradiate the upper surface of the print medium 110 with light in a specific wavelength range including infrared light for drying and fixing the ink 131 applied on the upper surface of the print medium 110.

In each of the first embodiment, the second embodiment, the third embodiment, and the fourth embodiment, for example, the printing unit 130 includes the line IJ head. However, the structure is not limited to this example. The printing unit 130 may include, for example, a serial IJ head.

In each of the first embodiment, the second embodiment, the third embodiment, and the fourth embodiment, for example, the printing unit 130 is not limited to a structure including the IJ head, and may have another structure different from the IJ head. For example, the printing unit 130 may include an electrostatic head. The electrostatic head may charge the print medium 110 and electrostatically apply a developer (toner) to the print medium 110 charged with static electricity. The printing unit 130 may feed the developer (toner) with, for example, a brush or a roller. The developer may be, for example, an ultraviolet curable toner curable in response to irradiation with ultraviolet light or a heat curable toner curable in response to irradiation with infrared irradiation.

In each of the first embodiment, the second embodiment, the third embodiment, and the fourth embodiment, for example, the ink 131 may be changed to a photoresist or a photocurable resin that is a photosensitive material.

In each of the first embodiment, the second embodiment, the third embodiment, and the fourth embodiment, for example, the light irradiator 10 is used in the printing apparatus 100 including the printing unit 130. However, the structure is not limited to this example. For example, the light irradiator 10 may be used in an apparatus for applying a paste containing a photosensitive resin such as a resist to a target surface such as a substrate by spin coating or screen printing and then curing the photosensitive resin. For example, the light irradiator 10 may be used as a light source for exposure in an exposure apparatus that exposes a photosensitive resin such as a resist to light.

In each of the first embodiment, the second embodiment, the third embodiment, and the fourth embodiment, for example, the light irradiator 10 may include the housing 11 with an upper outer surface including, in addition to the inclined surface 11c and the upper surface 11d, a stepped surface or another inclined surface. The inclined surface 11c and the upper surface 11d in the upper outer surface of the housing 11 may each have a size that is set as appropriate based on, for example, the specifications of the light irradiator 10. When the inclined surface 11c including the second vent 11h2 is larger than the upper surface 11d, the housing 11 may be smaller, and the components in the first space Sp1 in the housing 11 may be cooled efficiently with the expanded second vent 11h2.

In each of the first embodiment, the second embodiment, the third embodiment, and the fourth embodiment, for example, the light irradiator 10 includes the light-emission opening 4o with the center shifted from the center point of the lower surface 11a in the predetermined direction. However, the structure is not limited to this example. For example, the center of the light-emission opening 4o may be aligned with or adjacent to the center point of the lower surface 11a. For example, the printing apparatus 100 may include the light-emission opening 4o in the middle of the lower surface 11a in the feed direction of the print medium 110.

In each of the first embodiment, the second embodiment, the third embodiment, and the fourth embodiment, for example, the light irradiator 10 includes the first vent 11h1 and the second vent 11h2 each located in the area shifted from the area extending about the first imaginary central axis Ax1 at the center in the predetermined direction perpendicular to the first imaginary central axis Ax1. However, the structure is not limited to this example. For example, the first vent 11h1 and the second vent 11h2 may be located at positions opposite to each other with respect to the first imaginary central axis Ax1. This may reduce, for example, gas circulation in which a gas discharged from the first space Sp1 in the housing 11 to the second space Sp2 outside the housing 11 is introduced into the first space Sp1 in the housing 11 when air flows in and out through the first vent 11h1 and the second vent 11h2 in the light irradiator 10. The light emitter 2 is thus more likely to be cooled with the heat dissipator 3.

In each of the first embodiment, the second embodiment, the third embodiment, and the fourth embodiment, for example, the light irradiator 10 may not be used in, for example, the printing apparatus 100 and may be used in a structure in a field different from printing. For example, the light irradiator 10 may be used in assembly production including curing of adhesives or resins in electronic packaging. Curing of adhesives or resins may be a substantial degree of curing (precuring) of adhesives or resins. For example, an ultraviolet curable adhesive may be cured with ultraviolet light emitted from the light irradiator 10. For example, a heat curable adhesive may be cured with infrared light emitted from the light irradiator 10. For example, an adhesive curable by drying may be dried and cured with infrared light emitted from the light irradiator 10. For example, an ultraviolet curable resin curable in response to irradiation of ultraviolet light may be cured with ultraviolet light emitted from the light irradiator 10. For example, the light irradiator 10 may be used in drying such as irradiating targets with infrared light for efficient drying. For example, the light irradiator 10 may be used in healthcare for, for example, sterilization with ultraviolet light or violet light.

As described above, the light source module 1 and the light irradiator 10 have been described in detail, but the above structures are illustrative in all respects, and the present disclosure is not limited to the above structures. The above examples may be combined unless any contradiction arises. Examples other than those illustrated above may also be included without departing from the scope of the present disclosure.

The present disclosure provides the structures described below.

In one embodiment, (1) a light source module includes a light emitter including a plurality of light-emitting elements, a heat dissipator thermally connected to the light emitter, a cover including a first opening to allow light from the light emitter to pass and attached to the heat dissipator, a light-transmissive member covering the first opening to transmit light from the light emitter, a first cable electrically connected to the light emitter to supply power for light emission of the plurality of light-emitting elements, and a sealant covering a first clearance between the heat dissipator and the cover along a peripheral edge of the first clearance. The cover is made of a resin. The heat dissipator includes a base being a plate and a plurality of protrusions. The base includes a first surface that is a portion of the base adjacent to the cover, and a second surface opposite to the first surface. Each of the plurality of protrusions protrudes from the base in a direction away from the cover. The light emitter is between the first surface and the light-transmissive member. The cover includes a third surface that is a portion of the cover adjacent to the heat dissipator, a fourth surface opposite to the third surface, and a receding portion on the third surface. At least a part of the base is received in an internal space in the receding portion. In the internal space, a first area extends between the cover and the first surface. The first opening is open in the receding portion. The light source module further includes, between the receding portion and the base, a second opening connecting to the first area. The second opening receives the first cable extending from inside the first area to the outside of the receding portion. The sealant includes a first portion through which the first cable extends, and the first portion covers the second opening.
(2) In the light source module according to (1), the resin may have an elastic modulus lower than an elastic modulus of a material of the cover and an elastic modulus of a material of the heat dissipator.
(3) In the light source module according to (1) or (2), the plurality of light-emitting elements may emit ultraviolet light. The resin may include a resin resistant to ultraviolet light.
(4) In the light source module according to (1) or (2), the first cable may include a coating. The plurality of light-emitting elements may emit ultraviolet light. The resin may be more resistant to ultraviolet light than a material of the coating.
(5) The light source module according to any one of (1) to (4) may include a screw. The cover may be fastened and fixed to the heat dissipator with the screw. The screw may be made of a material having a thermal conductivity higher than a thermal conductivity of the resin.
(6) In the light source module according to any one of (1) to (5), the receding portion may include one or more first stepped portions each located in at least a part of an outer peripheral portion of the receding portion, and one or more projecting portions each spaced from the one or more first stepped portions and projecting toward the first surface. Each of the one or more first stepped portions may be in contact with at least a part of an outer peripheral area of the first surface along an outer edge of the first surface. Each of the one or more projecting portions may be in contact with the first surface.
(7) In the light source module according to any one of (1) to (6), the sealant may extend from the first clearance to the second surface.

In one embodiment, (8) a light irradiator includes the light source module according to any one of (1) to (7), a housing surrounding, together with the cover, the light emitter and the heat dissipator, and a drive including a drive circuit that drives the light emitter. The housing includes a first vent and a second vent each connecting a first space inside the housing and a second space outside the housing. The first vent is adjacent to a plurality of second clearances between the plurality of protrusions in a direction along the first surface. The second vent is located at a position opposite to the cover with respect to the heat dissipator. The first cable electrically connects the light emitter and the drive.

(9) The light irradiator according to (8) may include a blower between the heat dissipator and the second vent. The blower may blow air to the heat dissipator or to the second vent.

### REFERENCE SIGNS

- 1: light source module
- 10: light irradiator
- 11: housing
- 11h: vent
- 11h1: first vent
- 11h2: second vent
- 12: drive
- 13: blower
- 2: light emitter
- 21: light-emitting element
- 3: heat dissipator
- 31: base
- 31b: first surface
- 31p: receivable portion
- 31u: second surface
- 32: protrusion
- 32g: second clearance
- 4: cover
- 4b: fourth surface
- 4c1: receding portion
- 4o: light-emission opening
- 4p: projecting portion
- 4u: third surface
- 5: light-transmissive member
- 6: first cable
- 61: coating
- 7: sealant
- 9: screw
- A1: first area
- A3: outer peripheral area
- E1: peripheral edge
- E2: outer edge
- G1: first clearance
- Is1: internal space
- O2: second opening
- Os1: outside
- P1: first portion
- S11: first stepped portion
- Sp1: first space
- Sp2: second space

## Claims

1. A light source module, comprising:
a light emitter;
a heat dissipator;
a cover;
a light-transmissive member;
a first cable; and
a sealant,
wherein the light emitter includes a plurality of light-emitting elements,
the cover includes a first opening to allow light from the light emitter to pass, and the cover is attached to the heat dissipator,
the light-transmissive member covers the first opening and transmits light from the light emitter,
the first cable is electrically connected to the light emitter to supply power for light emission of the plurality of light-emitting elements,
the sealant covers a first clearance between the heat dissipator and the cover along a peripheral edge of the first clearance, and the sealant comprises a resin,
the heat dissipator includes a base being a plate and a plurality of protrusions,
the base includes a first surface and a second surface opposite to the first surface,
the first surface is a portion of the base adjacent to the cover,
each of the plurality of protrusions protrudes from the second surface,
the light emitter is between the first surface and the light-transmissive member,
the cover includes a third surface, a fourth surface opposite to the third surface, and a receding portion on the third surface,
the third surface is a portion of the cover adjacent to the heat dissipator,
at least a part of the base is received in an internal space in the receding portion,
the first opening is open in the receding portion,
the light source module further comprises, between the receding portion and the base, a second opening connecting to a first area extending between the cover and the first surface,
the first cable extends through the second opening,
the first cable extends through the sealant, and
the sealant covers the second opening.

2. The light source module according to claim 1, wherein
the resin has an elastic modulus lower than an elastic modulus of a material of the cover and an elastic modulus of a material of the heat dissipator.

3. The light source module according to claim 1 or claim 2, wherein
the plurality of light-emitting elements is configured to emit ultraviolet light, and
the resin includes a resin resistant to ultraviolet light.

4. The light source module according to claim 1 or claim 2, wherein
the first cable includes a coating,
the plurality of light-emitting elements is configured to emit ultraviolet light, and
the resin is more resistant to ultraviolet light than a material of the coating.

5. The light source module according to any one of claims 1 to 4, further comprising:
a screw,
wherein the cover is fastened and fixed to the heat dissipator with the screw, and
the screw comprises a material having a thermal conductivity higher than a thermal conductivity of the resin.

6. The light source module according to any one of claims 1 to 5, wherein
the receding portion includes one or more first stepped portions and one or more projecting portions,
each of the one or more first stepped portions is located in at least a part of an outer peripheral portion of the receding portion,
each of the one or more first stepped portions is in contact with at least a part of an outer peripheral area of the first surface along an outer edge of the first surface,
each of the one or more projecting portions is spaced from the one or more first stepped portions and projects toward the first surface, and
each of the one or more projecting portions is in contact with the first surface.

7. The light source module according to any one of claims 1 to 6, wherein
the sealant extends from the first clearance to the second surface.

8. A light irradiator, comprising:
the light source module according to any one of claims 1 to 7;
a housing; and
a drive,
wherein the housing surrounds, together with the cover, the light emitter and the heat dissipator,
the housing includes a first vent and a second vent,
the first vent connects a first space inside the housing and a second space outside the housing,
the first vent is adjacent to a plurality of second clearances between the plurality of protrusions in a direction along the first surface,
the second vent connects the first space and the second space,
the second vent is located at a position opposite to the cover with respect to the heat dissipator,
the drive includes a drive circuit configured to drive the light emitter, and
the first cable electrically connects the light emitter and the drive.

9. The light irradiator according to claim 8, further comprising:
a blower,
wherein the blower is between the heat dissipator and the second vent, and
the blower is configured to blow air to the heat dissipator or to the second vent.
